(19) Europäisches Patentamt
European Patent Office
Office européen des brevets

(11) EP 3 245 670 B1

(12) EUROPEAN PATENT SPECIFICATION

(45) Date of publication and mention
of the grant of the patent:
13.03.2019 Bulletin 2019/11

(51) Int Cl.:
H01L 21/84 (2006.01)          H01L 23/522 (2006.01)
H01L 23/552 (2006.01)         H01L 27/12 (2006.01)
H01L 21/768 (2006.01)

(21) Application number: 16700314.4

(22) Date of filing: 04.01.2016

(86) International application number:
PCT/US2016/012071

(87) International publication number:
WO 2016/114941 (21.07.2016 Gazette 2016/29)

(54) **INTEGRATED CIRCUIT ASSEMBLY WITH FARADAY CAGE**

INTEGRIERTE SCHALTUNGSANORDNUNG MIT FARADAYKÄFIG

ENSEMBLE CIRCUIT INTÉGRÉ À CAGE DE FARADAY

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 14.01.2015 US 201514596515

(43) Date of publication of application:
22.11.2017 Bulletin 2017/47

(73) Proprietor: QUALCOMM Incorporated
San Diego, CA 92121-1714 (US)

(72) Inventor: STUBER, Michael A.
San Diego, California 92121 (US)

(74) Representative: Howe, Steven
Reddie & Grose LLP
The White Chapel Building
10 Whitechapel High Street
London E1 8QS (GB)

(56) References cited:
WO-A2-02/067326          US-A1- 2006 255 434
US-A1- 2008 315 375      US-A1- 2010 078 779
US-A1- 2010 314 726      US-A1- 2013 049 215
US-A1- 2014 342 529      US-B1- 6 515 870
US-B1- 6 903 918         US-B1- 8 748 245

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

BACKGROUND OF THE INVENTION

In an integrated circuit, metal lines typically connect individual circuit elements together. The nature of this metal interconnect critically affects the performance and cost of the integrated circuit product. For example, most integrated circuit processes offer multiple levels of metal interconnect, in order to allow the maximum flexibility in circuit layout. This layout flexibility allows a designer to minimize the size of an integrated circuit, for example, reducing the cost of the product.

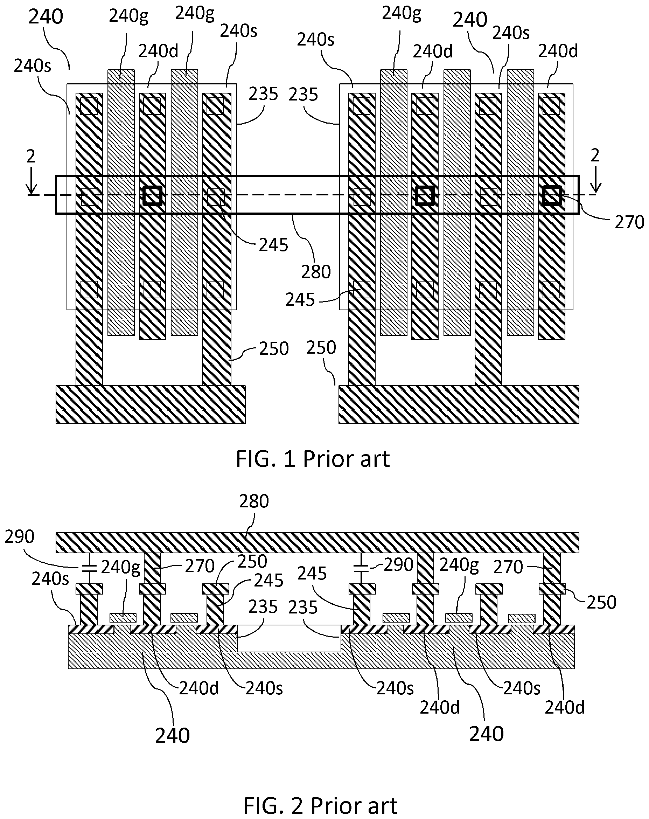

An example of a typical circuit layout with two levels of metal interconnect is shown in FIG. 1. This layout includes two metal-oxide-semiconductor field effect transistors (MOSFET) 240. Isolation edges 235 and gate fingers 240g define the transistors. One of the transistors 240 has two gate fingers 240g and one has three gate fingers. The gate shapes 240g and isolation edges 235 determine the source and drain regions of the transistors (240s and 240d, respectively). The drains 240d of both transistors 240 are electrically connected together, through contacts 245, first metal lines 250, inter-metal vias 270, and second metal line 280. The source regions 240s of the two transistors are connected individually through contacts 245 and first metal lines 250. The layout of FIG. 1 could be, for example, a complementary metal-oxide-semiconductor (CMOS) inverter, if one of the transistors 240 is an n-channel MOSFET and the other is a p-channel MOSFET.

In most multi-level metallization schemes, to connect upper-level metal lines to lower level metal lines or transistor electrodes (sources, drains, and gates), all of the intermediate metal layers and contacts or vias must be used. This can be seen in FIG. 1, where the second level metal line 280 is connected to transistor drains 240d through the first metal layer 250 and metal/diffusion contact 245. Thus, to connect source fingers 240s together, for example, a metal line 250 runs outside the transistor area to avoid shorting transistor sources 240s and drains 240d together. This increases the height, and thus the area, of the layout. Moreover, the width of this layout is determined by the minimum pitch of the contacted first metal lines, or the minimum pitch of the contacted source/drain regions - whichever is greater. If the minimum pitch of the contacted first metal lines is the greater of the two pitches, then this layout may be reduced in width by an alternative metallization scheme. Note that the minimum pitch of the contacted metal lines may be determined by lithographic or other process considerations, or it may be determined by electromigration concerns or other considerations/concerns.

The resistance (per unit length) and capacitance (per unit area) of the metal interconnect layers often has a direct impact on the performance of an integrated circuit. The interconnect structures and materials used affect, in turn, the resistance and capacitance of the interconnect lines. For example, the capacitance between a given interconnect line and the semiconductor substrate, or the capacitance between two interconnect lines, decreases as the vertical distance between them increases. If multiple interconnect layers are available, critical capacitances can be reduced by placing their nodes on metal layers that have more vertical separation between them.

To illustrate the origin of these parasitic capacitances, a cross-section of the layout of FIG. 1 is shown in FIG. 2. Parasitic capacitances, for example, between the gates 240g and the drain regions 240d (gate-drain capacitance) and the source 240s and drain 240d regions (off-state capacitance), are determined partly by the interconnect structure. For example, the overlap area between the first metal lines 250 and the source regions 240s forms a component of the off-state parasitic capacitance 290. The capacitance between the contact metal 245 and the transistor gates 240g contributes to the total gate-drain parasitic capacitance. Thus, the metallization scheme and layout has an effect on circuit parasitic capacitances, and therefore circuit performance.

These parasitic effects are important for high frequency and high speed circuits. Such circuits are often implemented on semiconductor-on-insulator (SOI) technology, which was first commercialized in the late 1990s. The defining characteristic of SOI technology is that the semiconductor region in which circuitry is formed is isolated from bulk substrate by an electrically insulating layer. This insulating layer is typically silicon dioxide. The advantageous aspects of SOI technology stem directly from the ability of the insulator layer to electronically isolate the active layer from bulk substrate.

SOI technology represents an improvement over traditional bulk substrate technology because the introduction of the insulating layer isolates the active devices in an SOI structure, which improves their electrical characteristics. For example, parasitic capacitances within the semiconductor region - depletion and diffusion capacitances, for example - are often reduced in SOI devices, especially those with thin enough semiconductor layers such that the transistors are "fully-depleted." Short-channel effects - the variation of the threshold voltage of a transistor with its channel length - are also reduced in SOI devices. For these reasons, among others, SOI is often the technology of choice for high-speed, low-power circuits. In addition, the SOFs insulating layer can act to shield the active devices from harmful radiation. This is particularly important for integrated circuits that are used in space given the prevalence of harmful ionizing radiation outside the earth's atmosphere.

Like bulk-substrate technologies, SOI technologies may also make use of multiple layers of metal interconnect. If these metal layers can be formed in such a way as to take advantage of the unique structure of SOI, cost and performance benefits can result. These performance benefits may be especially desirable for the types of circuits typically fabricated on SOI technologies - high-speed or high switching frequency, low-loss circuits.

In US 2010/078779 A1 of Barth et al, structures of a system on a chip is disclosed that includes an RF component disposed on a first part of a substrate, a semiconductor component disposed on a second part of the substrate, the semiconductor component and the RF component sharing a common boundary, and a conductive cage disposed enclosing the RF component, wherein he conductive cage shields the semiconductor component from electromagnetic radiation originating from the RF circuit.

SUMMARY OF THE INVENTION

The invention is defined by the independent claims.

According to an aspect, there is provided an integrated circuit assembly comprising: an insulating layer having a first surface and a second surface, the second surface being below the first surface; a semiconductor layer having a first surface and a second surface, the first surface of the semiconductor layer contacting the first surface of the insulating layer; an active device formed in a region of the semiconductor layer; a first electrically conductive interconnect layer forming an electrically conductive ring; a second electrically conductive interconnect layer forming a first electrically conductive plate above the electrically conductive ring and the region of the semiconductor layer; a third electrically conductive interconnect layer forming a second electrically conductive plate below i) the electrically conductive ring, ii) the insulating layer, and iii) the region of the semiconductor layer; a first dielectric layer between the first electrically conductive interconnect layer and the second electrically conductive interconnect layer; a second dielectric layer between the first electrically conductive interconnect layer and the third electrically conductive interconnect layer; and a plurality of electrically conductive vias electrically coupling the electrically conductive ring to the first electrically conductive plate through the first dielectric layer and to the second electrically conductive plate through the second dielectric layer; wherein the electrically conductive ring, the first electrically conductive plate, the second electrically conductive plate, and the plurality of electrically conductive vias form a Faraday cage around the active device.

According to a further aspect, there is provided a method comprising: providing a semiconductor wafer having an insulating layer, a semiconductor layer, and a substrate layer, the insulating layer having a first surface and a second surface, the second surface of the insulating layer being below the first surface of the insulating layer, the substrate layer contacting the second surface of the insulating layer, the semiconductor layer having a first surface and a second surface, the first surface of the semiconductor layer contacting the first surface of the insulating layer; forming an active device in a region of the semiconductor layer; forming a first electrically conductive interconnect layer with an electrically conductive ring; forming a second electrically conductive interconnect layer with a first electrically conductive plate above the electrically conductive ring and the region of the semiconductor layer, the second electrically conductive interconnect layer being formed with a first dielectric layer between the first electrically conductive interconnect layer and the second electrically conductive interconnect layer; removing the substrate layer from the second surface of the insulating layer; forming a third electrically conductive interconnect layer with a second electrically conductive plate below i) the electrically conductive ring, ii) the insulating layer, and iii) the region of the semiconductor layer, the third electrically conductive interconnect layer being formed with a second dielectric layer between the first electrically conductive interconnect layer and the third electrically conductive interconnect layer; and forming a plurality of electrically conductive vias electrically coupling the electrically conductive ring to the first electrically conductive plate through the first dielectric layer and to the second electrically conductive plate through the second dielectric layer; wherein the electrically conductive ring, the first electrically conductive plate, the second electrically conductive plate, and the plurality of electrically conductive vias form a Faraday cage around the active device.

In some embodiments, the electrically conductive ring is above the region of the semiconductor layer in which the active device is formed. In other embodiments, the electrically conductive ring is below this region of the semiconductor layer. In some embodiments, one or more additional electrically conductive rings are formed above or below this region. Each electrically conductive ring may have an opening through which an electrically conductive connection line may electrically connect the active device within the Faraday cage to one or more other active devices outside the Faraday cage. Additionally, in some embodiments, the first and second electrically conductive plates are perforated with holes that reduce a capacitance to ground of the active device within the Faraday cage. Furthermore, in some embodiments, a handle wafer having a substrate may be bonded above the electrically conductive interconnect layers, so that all of the electrically conductive interconnect layers are on one side of the overall structure.

BRIEF DESCRIPTION OF THE DRAWINGS

    FIG. 1 illustrates a typical integrated circuit layout with two layers of metal.

    FIG. 2 illustrates a cross-section of the circuit layout shown in FIG. 1.

    FIG. 3 shows a process flow chart of a method of fabricating an integrated circuit with metal interconnects on the back side of an SOI insulator that is in accordance with a specific embodiment of the present invention.

FIGs. 4A-G show cross-sectional views of stages of forming interconnect on the back side of an SOI circuit, according to some embodiments.

FIG. 5 shows a cross-sectional view of another embodiment, wherein multiple types of back contacts are formed.

FIG. 6 shows a layout of an SOI integrated circuit using back side interconnect that is in accordance with a specific embodiment of the present invention.

FIGs. 7A-B show an alternative layout and cross section of an SOI integrated circuit using back side interconnect that is in accordance with a specific embodiment of the present invention.

FIG. 8 shows a cross-sectional view of transistors formed using an embodiment of the current invention, illustrating differences in parasitic capacitances.

FIGs. 9A-C show cross-sectional views of stages of forming back side diffusions and interconnect, according to some embodiments.

FIGs. 10A-C show cross-sectional views of stages of forming back side contacts and interconnect, according to some embodiments.

FIG. 11 is a simplified cross section of a portion of an integrated circuit assembly with a Faraday cage in accordance with an embodiment.

FIG. 12 is a simplified cross section of a portion of another integrated circuit assembly with a Faraday cage in accordance with an alternative embodiment.

FIG. 13 is a simplified layout view of a portion of the integrated circuit assembly shown in either FIG. 11 or 12 in accordance with an embodiment.

FIG. 14 is a simplified layout view of another portion of the integrated circuit assembly shown in FIG. 11 in accordance with an embodiment.

DETAILED DESCRIPTION OF THE EMBODIMENTS

High-speed, high performance integrated circuits are often fabricated using silicon-on-insulator (SOI) technologies. SOI technologies also lend themselves to layer-transfer techniques, where the active layer of the SOI is transferred, using bonding and etch-back methods, to a different substrate. This method may have advantages of lower capacitance and higher speed, easier thermal management, and easier access to the body regions of SOI transistors. An example of such a process is described in U.S. Patent No. 8,357,935 entitled, "Silicon-on-insulator with back side connection", owned by the assignee of the present application and filed on April 28, 2012, which is incorporated herein by reference in its entirety. Layer transfer techniques may also be used to form circuits on fully insulating or transparent substrates, which may be advantageous in opto-electronic applications, for example.

Transferring the active layer of an integrated circuit also can expose the surface of the insulator layer (opposite the active devices) to further processing, if desired. In particular, a full interconnect layer can be formed on this insulator layer surface after the substrate is removed. An interconnect layer so placed may contact the transistor source and drain regions through holes etched in the SOI's insulating layer. This arrangement offers added layout flexibility. Also, this back side interconnect layer provides lower parasitic capacitance when compared to traditional, front-side interconnect layers. Lastly, such an interconnect layer aids in dissipating heat generated by the SOI integrated circuit. The problems with heat dissipation on SOI circuits, and some proposed solutions, are described in U.S. Patent Publication No. 2011/0012199 entitled, "Semiconductor-on-insulator with back-side heat dissipation," owned by the assignee of the present application and filed on July 14, 2010, which is incorporated herein by reference in its entirety.

In one embodiment, a full back side SOI interconnect layer connects a plurality of active or reactive devices together, providing a lower cost alternative for providing high performance SOI integrated circuits. Various embodiments include: reducing contact resistance to the back side of the active layer by forming heavily-doped regions through the back side contacts, or etching through the active layer to contact heavily doped or silicided areas on the front surface of the active layer. If the transferred structure can withstand higher temperatures, more process flexibility is possible.

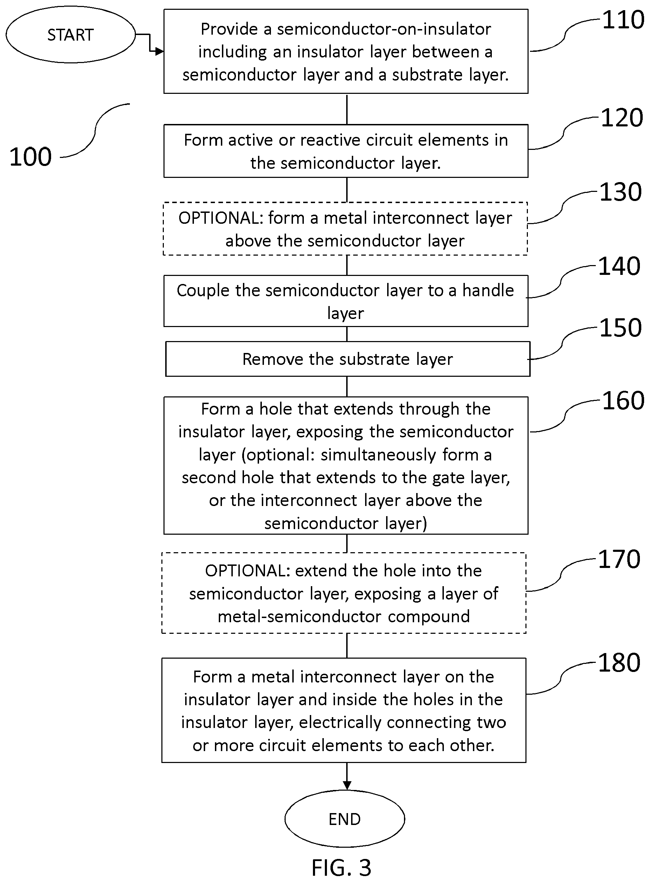

FIG. 3 illustrates some embodiments of methods of the present disclosure, where a metal interconnect layer is formed on the back side of an SOI integrated circuit. In flowchart 100 of FIG. 3, a semiconductor-on-insulator structure is provided in step 110. This structure includes an insulator layer disposed between a semiconductor layer and a substrate layer. The insulator layer may be, for example, silicon dioxide, which may be 15 - 1000 nm thick. In step 120, active or reactive circuit elements are formed in the semiconductor layer. Such elements may include, for example, n-channel and p-channel MOS (NMOS and PMOS) transistors. The semiconductor layer may be removed in certain areas - for example, in the isolation areas located between active devices - and replaced with dielectric. These elements may be formed using, for example, a standard CMOS process, or a bi-polar-CMOS (BiCMOS) process, or a process that forms high-power devices or optoelectronic devices in addition to MOS transistors. This process may include forming a metal-semiconductor compound on regions of the semiconductor layer; for example, on the source and drain regions of the MOSFETs. Such a compound would reduce the sheet resistance of these regions. If the semiconductor layer comprises silicon, the metal-semiconductor compound may comprise, for example, titanium silicide, cobalt silicide, or nickel silicide. In step 130, a metal interconnect layer is optionally formed above the semiconductor layer. This layer may electrically connect to the circuit elements formed in the semiconductor layer.

This layer may be formed using a subtractive, or Damascene, process, or it may be formed using an additive process. This layer may be comprised, for example, of a refractory metal, for example, tungsten.

In step 140 of FIG. 3, a handle layer is coupled to the semiconductor layer of the SOI structure. The handle layer could be any rigid or semi-rigid support, for example, a silicon wafer. Any suitable coupling or bonding method that results in a permanent bond may be used; for example direct or fusion bonding, permanent adhesive bonding, metallic interdiffusion or eutectic bonding. If a front-side interconnect layer is used (step 130), it may be advantageous for bonding purposes to use a Damascene process to form this layer, since a planar surface will result. A bonding layer, for example, silicon dioxide, may be deposited on the SOI structure, or the handle layer, or both. This layer may be deposited using, for example, chemical vapor deposition (CVD). In step 150, the substrate layer of the SOI is removed. This could be done by using, for example, mechanical and chemical means independently or in combination.

Still referring to FIG. 3, in step 160, a hole is etched in the exposed surface of the insulator layer. This hole extends through the insulator layer, from one surface to the opposite surface. This may be accomplished, for example, by forming the hole pattern in a photoresist using photolithography, and etching the insulator layer in an RIE or plasma etch chamber, or using hydrofluoric acid (HF). After the hole is formed, the semiconductor layer surface is exposed inside the hole. During the etching step 160, another hole that extends to a transistor gate layer, or to the (optional) interconnect layer formed in step 130, may be formed. Such a hole could be formed, for example, through the dielectric isolation areas between the active or reactive devices. All of these different types of holes - those extending to the semiconductor layer, a gate layer, or an interconnect layer - are etched through the same material (for example, silicon dioxide). Thus, they can all be etched in the same step 160. In step 170, the hole extending to the semiconductor layer may optionally be extended into the semiconductor. The etching may stop at the metal-semiconductor compound layer, if present. This etching process may be done in a dry-etch chamber, using a chemistry that will etch the semiconductor faster than the metal-semiconductor compound. For example, for a silicon layer with nickel silicide formed on the front surface, an $SF_6 + O_2$ etch will etch the silicon but not etch the nickel silicide.

In step 180 of FIG. 3, a metal interconnect layer is formed on the back side of the insulator and inside the hole formed in step 160. This metal interconnect layer could comprise, for example, tungsten plugs, aluminum, copper, or a combination of these. It could be formed by standard patterning techniques; for example, depositing the metal, patterning with a photoresist, and etching the metal. The resulting pattern will connect two or more of the devices formed in the semiconductor layer to each other. If there are holes formed in step 160 that extend to a gate layer or a front-side metal interconnect layer (if step 130 is performed), then an electrical connection can be formed between the back side metal formed in step 180 and a gate or front side metal layer.

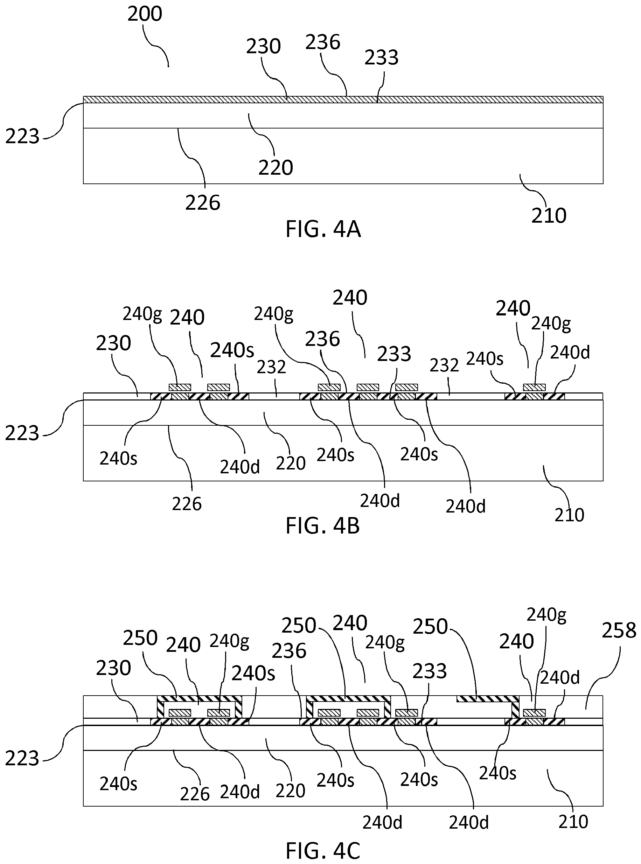

FIGs. 4A-G illustrate an exemplary back side SOI structure fabricated according to the method of FIG. 3. In FIG. 4A, an SOI structure 200, having a substrate layer 210, an insulating layer 220, and a semiconductor layer 230, is provided. The insulating layer 220 has a first surface 223 (in contact with the semiconductor layer 230) and a second surface 226 in contact with the substrate 210. The semiconductor layer 230 has a first surface 233 (in contact with the first surface 223 of the insulating layer 220) and a second surface 236. The insulating layer may be comprised of, for example, silicon dioxide, and it may be, for example, between 10 and 1000 nm thick, for example, between 15 and 70 nm thick, or between 150 and 350 nm thick, or between 500 and 750 nm thick. The semiconductor layer may be comprised of, for example, silicon, or a III-V semiconductor such as GaAs, or a strained semiconductor alloy such as SiGe.

In FIG. 4B, circuit elements, for example, transistors 240, are formed in the semiconductor layer. These transistors 240 comprise source 240s and drain 240d regions, and gate layers 240g, and are separated by isolation regions 232. These elements may be formed as described for step 120 in FIG. 3 above; that is, using, for example, a standard CMOS process, or a bi-polar-CMOS (BiCMOS) process. Other circuit elements may be formed in addition to, or instead of, CMOS transistors 240, for example, high-power devices, optoelectronic devices, or other passive or reactive elements.

The source 240s and drain 240d regions in FIG. 4B comprise areas of the semiconductor layer that are heavily doped, in comparison, for example, to the transistor channel regions underneath the gates 240g. The high doping level is important, for example, to allow good electrical contact to these regions. If the semiconductor layer is thin enough - for example, less than 100 nm, or less than 70 nm, or less than 50 nm - the source and drain heavily-doped regions may extend through the full thickness of the semiconductor layer, as shown in FIG. 4B. Note also that the source 240s and drain 240d regions of transistors 240 may be raised above the surface 236 of the semiconductor layer 230. Such a structure is often used for fully-depleted SOI processes, which are built on very thin semiconductor layers, for example, less than 20 nm, or less than 10 nm, or between 5 and 7 nm.

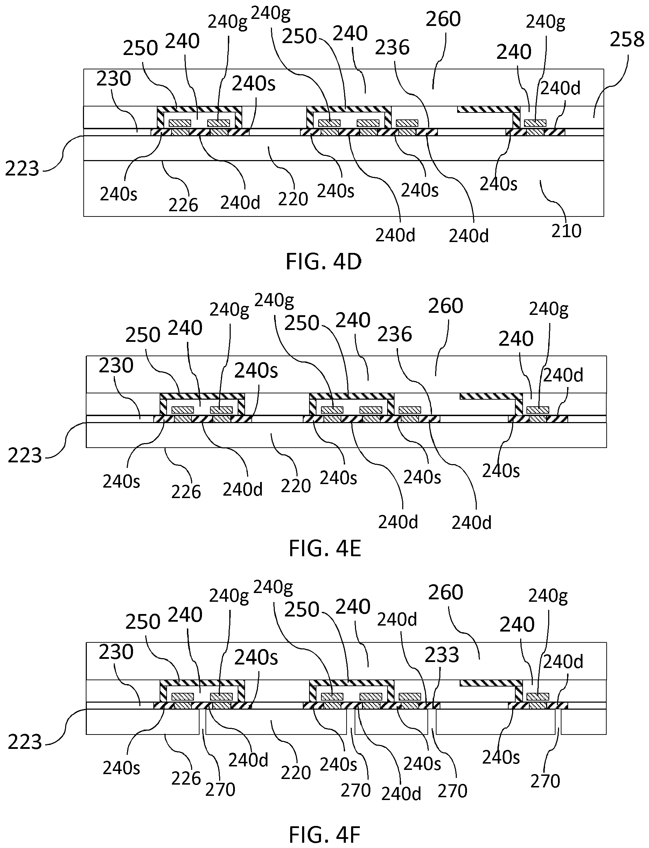

FIG. 4C shows a front metal interconnect layer 250 optionally coupled to the second surface 236 of the semiconductor layer 230, and above the circuit elements (transistors 240) fabricated therein. If present, this interconnect layer 250 may connect, for example, to the source regions 240s of the transistors 240. A subtractive, or Damascene, process may be used to form optional interconnect layer 250. Interconnect layer 250 may comprise a high-temperature capable interconnect, for example, a refractory metal, for example, tungsten. Alternatively, interconnect layer 250 may comprise a conventional low-resistivity material, for example, copper or aluminum, or it may comprise a combination of high-temperature-capable interconnect and low-resistivity material, for example tungsten plugs with aluminum or copper metal. An inter-level dielectric layer 258 separates the optional front metal interconnect layer 250 from the devices 240 formed in the semiconductor layer 230. In FIG. 4D, a handle layer 260 is coupled to the surface 236 of the semiconductor layer 230, with inter-level dielectric layer 258 and front interconnect layer 250, if present, intervening. As shown in FIG. 4D, handle layer 260 is bonded above interconnect layer 250, if present. As described in step 140 of FIG. 3, the handle layer could be any rigid or semi-rigid support, for example, a silicon wafer, and any suitable coupling or bonding method that results in a permanent bond may be used; for example direct or fusion bonding, or permanent adhesive bonding. A bonding layer (not shown), for example, deposited silicon dioxide, may be formed on the either, or both, of the bonded surfaces.

In FIG. 4E, the substrate 210 of the SOI structure has been removed, by using, for example, mechanical and chemical means independently or in combination. This step exposes the surface 226 of the insulator layer 220. In FIG. 4F, holes 270 have been etched through the insulator layer 220, exposing regions of the surface 233 of the semiconductor layer 230. These holes can be formed by any standard patterning technique as described above for step 160 in FIG. 3, for example, photolithographic patterning of a resist layer followed by dry etching of the insulator layer 220. These holes may expose, for example, the drain regions 240d of transistors 240. Holes could also expose, for example, source or body regions of CMOS transistors, or collector regions of vertical bipolar transistors, or collector, base, or emitter regions of lateral bipolar transistors.

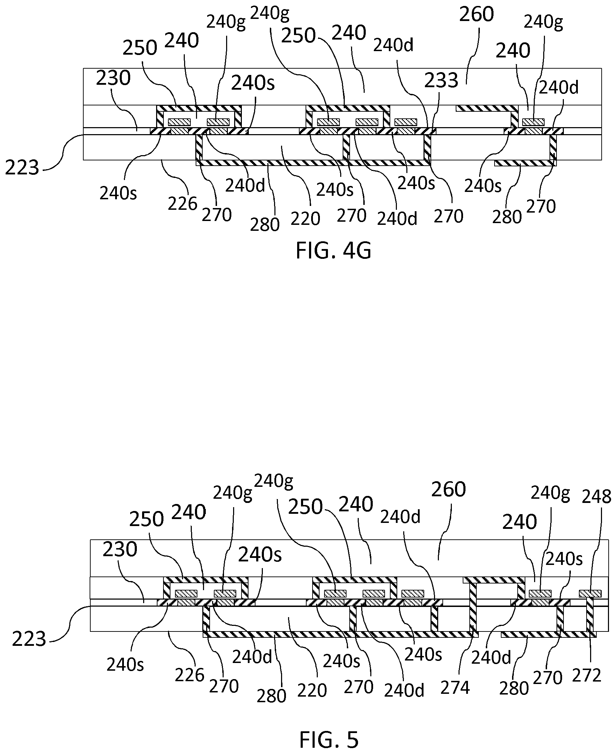

Turning to FIG. 4G, a back side metal interconnect layer 280 is formed on the surface 226 of insulator layer 220 and inside the holes 270. As described in step 170 of FIG. 3, this metal interconnect layer could comprise, for example, aluminum, copper, tungsten, or a combination of these. It could be formed by standard patterning techniques; for example, an additive process, or a subtractive process. The back side metal layer 280 may connect two or more transistors 240 to each other. For example, as shown in FIG. 4G, back side metal layer 280 may connect some of the drains 240d of transistors 240 together.

FIG. 5 shows an alternative structure that may be formed using the process according to the method of FIG. 3. In FIG. 5, other holes 272 and 274 are formed, in addition to holes 270. Both holes 272 and 274 are formed over isolation regions between transistors 240. Hole 272 extends to a gate region 248 that extends over the isolation region, and hole 274 extends to the optional front metal interconnect layer 250. Holes 272 and 274 may be formed simultaneously with holes 270; that is, in the same masking step. Alternatively, separate masking steps may be used for the different types of contact holes, for example, if it is desired that the overetch of the semiconductor layer inside holes 270 be minimized. In this structure, the back side interconnect is electrically connected to the optional front side interconnect, or the transistor gate layer, or both. This can allow greater layout flexibility and thus cost savings.

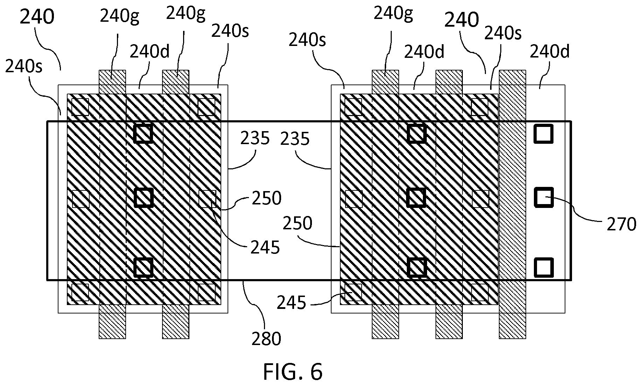

FIG. 6 shows an example layout that utilizes the area-saving features of this invention. As in FIG. 2, gate fingers 240g and isolation edges 235 define transistors 240. Transistors 240 further comprise drain regions 240d and source regions 240s. A front side metal interconnect layer 250 connects the source regions 240s together through contacts 245. Note that there is no connection between interconnect layer 250 and the drain regions 240d; therefore, the metal layer 250 connecting the source regions 240s can be drawn overlapping the drain regions 240d without going outside of the transistor area. Drain regions 240d are connected through back side holes (or vias) 270 to back side interconnect layer 280. In this way, the area of this integrated circuit can be reduced compared to the prior art shown in FIG. 2.

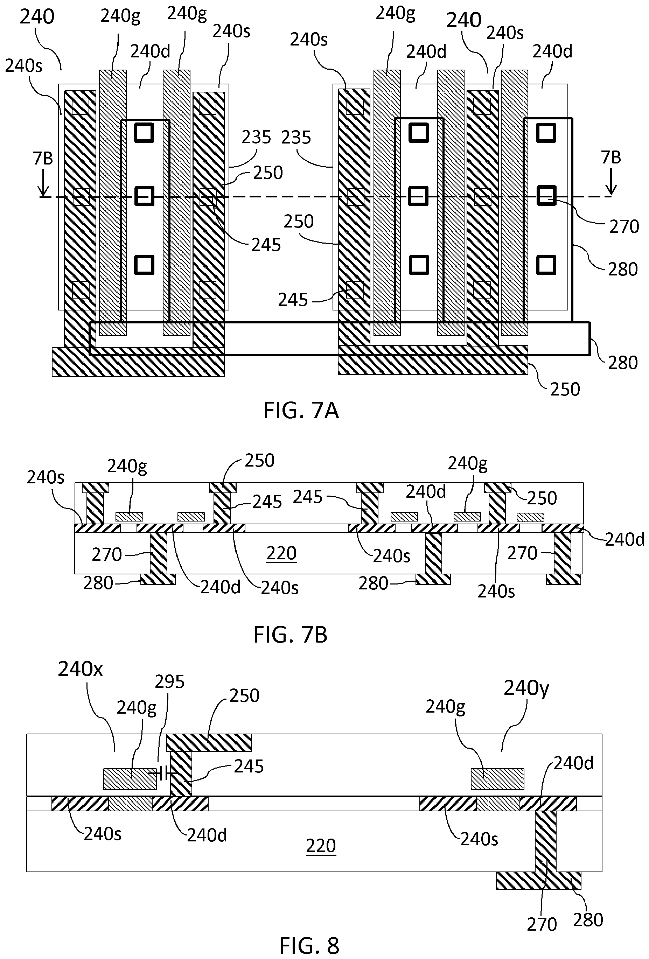

FIG. 7A shows an example layout for the reduction of parasitic capacitance. Again, gate fingers 240g and isolation edges 235 define the source 240s and drain 240d regions of transistors 240. Front side metal 250 is again connected to the source regions 240s through contacts 245. Back side metal 280 is connected to drain regions 240d through back side vias 270. So as to reduce gate-to-source (off-state) capacitance, the source metal 250 is not drawn overlapping the drain regions 240d, and the back side drain metal 280 is not drawn overlapping the source regions 240s. Thus, the interconnect contribution to the parasitic off-state capacitance is limited to the area of overlap of the back side metal 280 and front side metal 250 layers. However, this capacitance is much reduced compared to the case of FIG. 2, since the two layers are more separated vertically. FIG. 7B shows a cross sectional view of the layout illustrated in FIG. 7A. This figure clearly shows how the front side source metal 250 and the back side drain metal 280 are separated from each other as far as they can be.

Using this embodiment, where the back side metal 280 connects to drain regions 240d, the gate-to-drain capacitance is also reduced. FIG. 8 shows a cross section of two transistors 240x and 240y fabricated using an embodiment of the current invention. Transistor 240x has its drain 240d contacted from the front, and transistor 240y has its drain 240d contacted from the back. The gate-drain capacitance for transistor 240x includes as a component the capacitance 295 between the front contact 245 and the gate 240g. However, for the back-contacted transistor 240y, there is no such capacitance adding to the total gate-drain capacitance. Thus, the total gate-drain capacitance is reduced for transistors with back-contacted drains.

Note also that, in the transistor layouts (FIG. 6 and FIG. 7), the transistors 240 may be more compacted in the direction perpendicular to the gate fingers 240g, compared to layouts using standard processes (e.g., FIG. 2). This is the case if the minimum front-side contacted metal pitch is greater than the minimum contacted transistor source/drain pitch, which would make the layout of FIG. 2 metal-pitch limited. As shown in FIGs. 6 and 7, the number of front side metal pitches needed to contact the sources and drains of the transistors 240 is reduced by about a factor of 2.

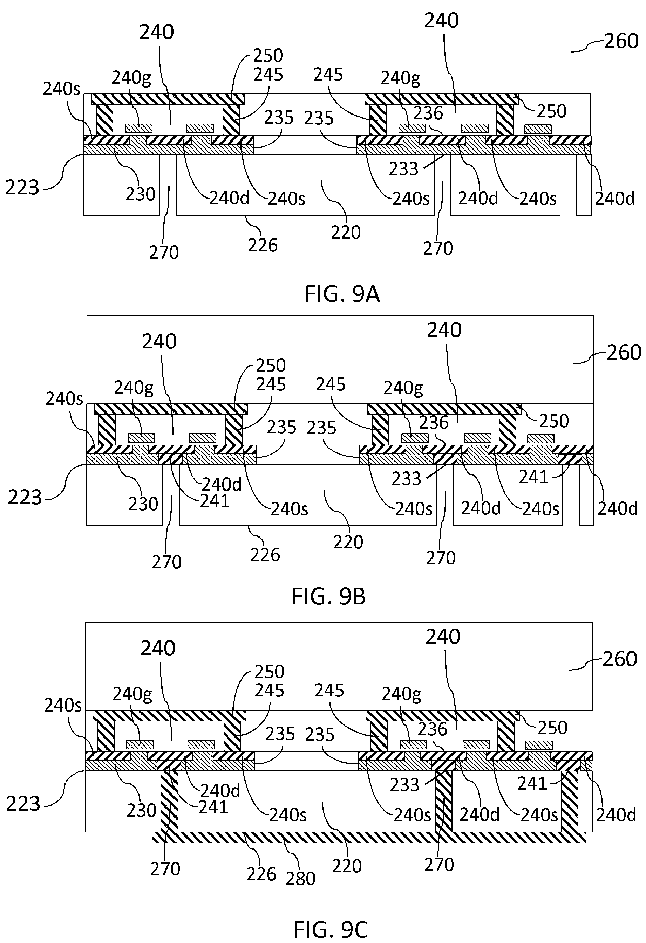

FIGs. 9A-C illustrate an alternative embodiment of an SOI back side metal interconnect. FIG. 9A shows an SOI integrated circuit, with transistors 240 and front-side interconnect layer 250, bonded to handle layer 260. Heavily doped source regions 240s and drain regions 240d do not extend through to the back surface 233 of semiconductor layer 230. Holes 270 have been etched in insulator layer 220 to expose surface 233 of semiconductor layer 230. In FIG. 9B, dopant has been introduced inside holes 270 to form doped regions 241, of the same dopant type as drain regions 240d. Regions 241 effectively extend drain regions 240d to the back surface 233 of semiconductor layer 230, and allow the drain regions 240d to be contacted through back side holes 270. Doped regions 241 may be formed by, for example, implanting dopant ions through holes 270, as described in U.S. Patent Publication No. 2012/0088339 A1 entitled, "Vertical Semiconductor Device with Thinned Substrate," owned by the assignee of the present application and filed on October 11, 2011, which is incorporated herein by reference in its entirety. Alternatively, doped regions 241 may be formed by exposing the structure to a dopant-species-containing ambient (for example, $POCl_3$) at a high temperature (for example, greater than 800 °C). If ion implantation is used, it may be followed by an annealing process to activate the dopant, for example, a rapid thermal anneal at a temperature of 800 to 1000 °C for 1 to 60 seconds. Note that, if a high temperature process is used for this step, it would be advantageous to use a high temperature metal for the front side metal interconnect layer 250, if this layer is used. For example, it would be advantageous if a refractory metal, for example, tungsten, were used for front side metal interconnect 250.

In FIG. 9C, a back side metal interconnect layer 280 is formed on the surface 226 of insulator layer 220 and inside the holes 270, contacting doped region 241 connected to drain regions 240d. This metal interconnect layer could comprise, for example, tungsten, aluminum, copper, or a combination of these. This interconnect layer may, as shown in FIG. 9C connect the drains 240d of transistors 240 together, through back side vias 270 and doped regions 241.

The process described in FIGs. 9A-B provide a means of forming a back-side interconnect contacting drain or source regions, when these regions do not extend to the back side of the semiconductor layer. This may be the case, for example, if the semiconductor layer is greater than 200 nm thick, or greater than 100 nm thick, or greater than 70 nm thick.

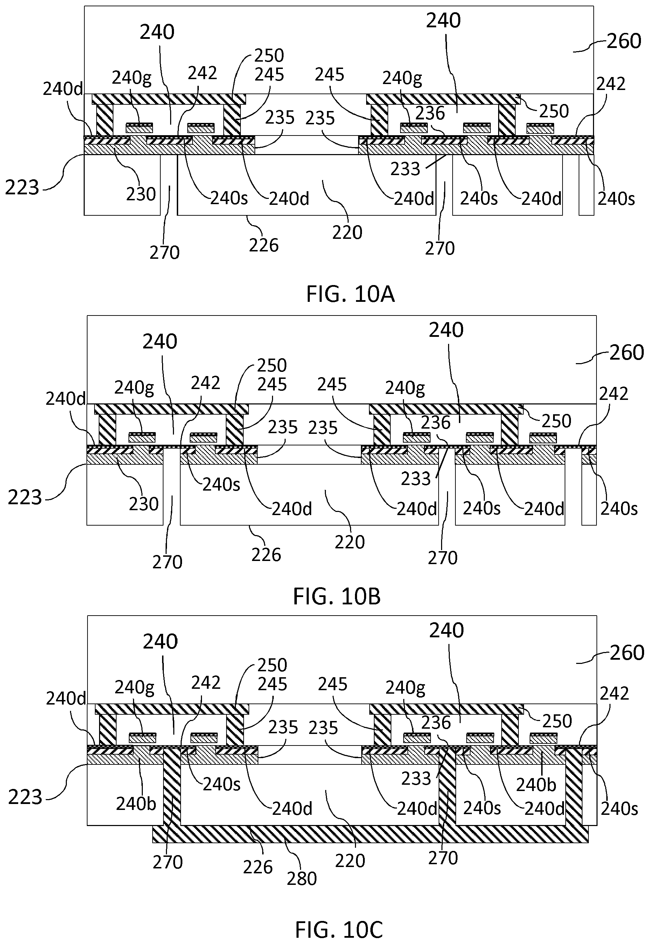

FIGs. 10A-C illustrate another alternative embodiment of an SOI back side metal interconnect. FIG. 10A shows an SOI integrated circuit, with transistors 240 and front-side interconnect layer 250, bonded to handle layer 260. Heavily doped source regions 240s and drain regions 240d do not extend through to the back surface 233 of semiconductor layer 230. Moreover, regions of a metal-semiconductor compound 242 have been formed on the surfaces of the drain regions 240d, source regions 240s, and gate regions 240g of transistors 240. These metal-semiconductor compounds are often used to reduce the sheet resistance and contact resistance of these regions. If the semiconductor layer comprises silicon, the metal-semiconductor compound may comprise, for example, titanium silicide, cobalt silicide, or nickel silicide. These regions are often referred to as "self-aligned silicide", or "SAlicide", regions.

Still referring to FIG. 10A, holes 270 have been etched in insulator layer 220 to expose surface 233 of semiconductor layer 230. In FIG. 10B, the holes 270 have been extended into the semiconductor layer 230 to contact the back side of the metal-semiconductor compound regions 242. This etching process may be done in a dry-etch chamber, using a chemistry that will etch the semiconductor faster than the metal-semiconductor compound. For example, for a silicon layer with nickel silicide formed on the front surface, an $SF_6 + O_2$ etch will etch the silicon but not etch the nickel silicide. In FIG. 10C, a back side metal interconnect layer 280 is formed on the surface 226 of insulator layer 220 and inside the holes 270, contacting metal-semiconductor compound regions 242 electrically connected to source regions 240s. This metal interconnect layer could comprise, for example, tungsten, aluminum, copper, or a combination of these.

The structure of FIG. 10C offers several advantages. For example, the transferred semiconductor layer 230 does not need to be exposed to high temperature steps (e.g., to activate dopants), so that low-resistivity, low-temperature metals (e.g., aluminum or copper) may be used for the front-side metal interconnect layer, if present. Also, the hole 270 filled with interconnect metal 280 contacting the metal-semiconductor compound region 242 together provide an excellent thermal path for efficient transfer of heat from active devices 240. Finally, the contact resistance between the metal-filled hole 270 and the metal-semiconductor compound 242 may be advantageously lower than the metal-semiconductor contact resistance between metal-filled holes 270 and the silicon surface 233 (FIG. 4G and FIG. 9C).

In FIG. 10C, the back side interconnect layer 280 is shown connecting transistor sources 240s rather than transistor drains 240d. In this structure as shown, there may be some conduction between the metal filling the hole 270 and the body region 240b of the transistor 240. Thus, in FIG. 10C, the sources and body regions of transistors 240 may be effectively shorted together. For many circuits, especially digital circuits, this is desired.

For these types of circuits, then, this structure may offer a layout advantage, since a separate body contact is not necessary.

The process described in FIGs. 10A-C may also be used in combination with the process wherein the diffused regions reach the back side of the semiconductor layer 230 (FIGs. 4A-G). This may be advantageous, for example, in cases a lower drain contact resistance is desired. This structure is also less susceptible to unintended conduction between the metal filling the holes 270 and the body regions of transistors 240, so, for example, analog or other circuits, where source-body ties are not necessarily desired, may be implemented.

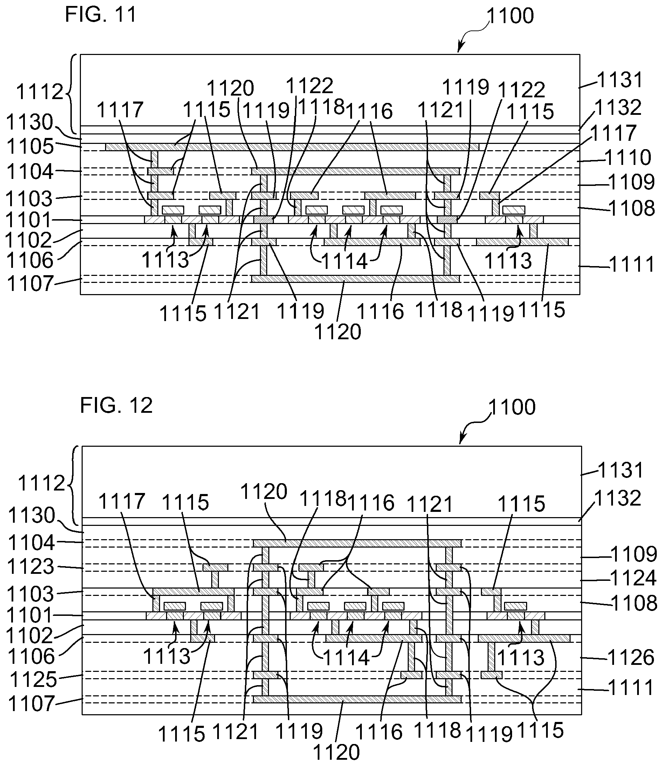

Some of the above described processes and structures may be used to form an example integrated circuit (IC) assembly 1100 with a Faraday cage, as shown in FIG. 11, in accordance with an embodiment. The Faraday cage is generally integrated into an IC chip that includes a variety of electronic components and active device structures. The Faraday cage surrounds and electromagnetically isolates one or more of the active device structures that need to be shielded from electromagnetic (E/M) noise or interference generated by other components in the overall IC chip or adjacent thereto.

In some embodiments, the structure and fabrication technique of the Faraday cage enable the components therein to primarily include the active device structures that are to be shielded with minimal additional material or structures enclosed thereby. The size or volume of the Faraday cage is thus generally minimized, thereby also minimizing the exposure of the contained active device structures to external E/M influences.

Additionally, in some embodiments, the structure and fabrication technique of the Faraday cage enable all electrically conductive interconnect layers (e.g. metallization, conductive polysilicon, etc.) to be on one side of a wafer or substrate. With this design, the side of the wafer or substrate that does not have electrically conductive interconnect layers can be removed or thinned near the end of overall processing to make the overall wafer any desired thickness. Also, since one side of the wafer or substrate does not have electrically conductive interconnect layers, handling of the die is simpler or easier, because there is no need to be concerned about scratching any back side metal during wafer and die handling. Furthermore, with no back side metal on the die, there is no concern over shorting any back side metal to the same potential if the die is placed on a package with a metal leadframe. The circuit design, thus, has the flexibility to be used in a variety of different packaging solutions.

The integrated circuit assembly 1100 is shown simplified and idealized in some respects for ease of illustration and description, and the components thereof are not drawn to scale nor intended to represent any particular type of electronic circuitry. The components are shown merely for illustrative and explanatory purposes. In the illustrated embodiment, the integrated circuit assembly 1100 generally includes a semiconductor layer 1101, an insulating layer 1102, electrically conductive interconnect layers 1103-1107, inter-level dielectric layers 1108-1111, and a handle wafer/layer 1112, among other appropriate components not shown for simplicity. A variety of active devices 1113 and 1114, which may be similar to the transistors or active devices described above, are formed in and on various regions of the semiconductor layer 1101 and extend into the first inter-level dielectric layer 1108. The electrically conductive interconnect layers 1103-1107 generally include electrically conductive connection lines 1115 and 1116 separated by the inter-level dielectric layers 1108-1111. Electrically conductive vias 1117 and 1118 electrically connect the electrically conductive connection lines 1115 and 1116 and the active devices 1113 and 1114 through the inter-level dielectric layers 1108-1111 and the insulating layer 1102. The electrically conductive connection lines 1115 and 1116 and the electrically conductive vias 1117 and 1118 electrically connect the active devices 1113 and 1114 to form the electronic circuitry of the integrated circuit assembly 1100.

In addition to the electrically conductive connection lines 1115 and 1116, the electrically conductive interconnect layers 1103-1107 also have electrically conductive connection lines 1119 and 1120 formed therein. The electrically conductive connection lines 1119 and 1120 are electrically connected by electrically conductive vias 1121 formed through the inter-level dielectric layers 1108, 1109, and 1111 and the insulating layer 1102. The electrically conductive connection lines 1119 are shown on the left and right side of the active devices 1114, because these connection lines generally form electrically conductive rings around upper and lower (i.e., sub-insulator) regions of the electrically conductive interconnect layers 1103 and 1106 above and below the region of the active devices 1114. Portions of the rings of the electrically conductive connection lines 1119 are not shown in FIG. 11, however, because they are outside of the plane of the cross section thereof. The electrically conductive connection lines 1120 generally form electrically conductive plates above and below the active devices 1114 and the rings of the electrically conductive connection lines 1119. The rings of the electrically conductive connection lines 1119, the plates of the electrically conductive connection lines 1120, and the electrically conductive vias 1121 generally form the Faraday cage around the active devices 1114. In some embodiments, the Faraday cage is grounded to facilitate the E/M screening.

In some embodiments, an electrically conductive ring of polysilicon 1122 may be formed in the semiconductor layer 1101 along with the active devices 1113 and 1114. The electrically conductive ring of polysilicon 1122, thus, generally surrounds the region of the semiconductor layer 1101 in which the active devices 1114 are formed. Additionally, the electrically conductive vias 1121 also electrically couple the rings of the electrically conductive connection lines 1119 to the electrically conductive ring of polysilicon 1122. In these embodiments, the electrically conductive ring of polysilicon 1122, therefore, also forms part of the Faraday cage.

In some embodiments, one or more additional rings of the electrically conductive connection lines 1119 may be formed between the plates of the electrically conductive connection lines 1120, as shown in FIG. 12. For example, additional electrically conductive interconnect layer 1123 and additional inter-level dielectric layer 1124 have been added between the electrically conductive interconnect layer 1103 and the inter-level dielectric layer 1109 above the region of the active devices 1114. Similarly, additional electrically conductive interconnect layer 1125 and additional inter-level dielectric layer 1126 have been added between the electrically conductive interconnect layer 1106 and the inter-level dielectric layer 1111 below the region of the active devices 1114. Thus, additional rings of the electrically conductive connection lines 1119 may be formed in the additional electrically conductive interconnect layers 1123 and 1125. Furthermore, the electrically conductive vias 1121 form electrical connections through these additional rings. In these embodiments, therefore, the additional rings of the electrically conductive connection lines 1119 and additional electrically conductive vias 1121 also form part of the Faraday cage.

In the embodiments illustrated in FIGS. 11 and 12, either two or four rings of the electrically conductive connection lines 1119 are used. However, any appropriate smaller or larger number of the rings of the electrically conductive connection lines 1119 may be used. In some embodiments, for example, the Faraday cage includes at least one of the rings of the electrically conductive connection lines 1119, while the other rings (including the electrically conductive ring of polysilicon 1122 in FIG. 11) are optional.

The number of the rings of the electrically conductive connection lines 1119 present in any particular embodiment may depend on the need for electrically conductive interconnect lines between the active devices 1114 inside the Faraday cage and the active devices 1113 outside the Faraday cage. Such electrically conductive interconnect lines are generally formed similar to the top/front side interconnect layers and/or bottom/back side interconnect layers described above (e.g., front side interconnect layer 250 and back side interconnect layer 280). Alternatively, polysilicon or other less-conductive layers may also be used for signal propagation into and out of the Faraday cage. This variation may reduce noise propagation into the Faraday cage from signal lines outside the Faraday cage. Also, filters (e.g., RC filters or active filters) may be used to filter noise at specific frequency ranges.

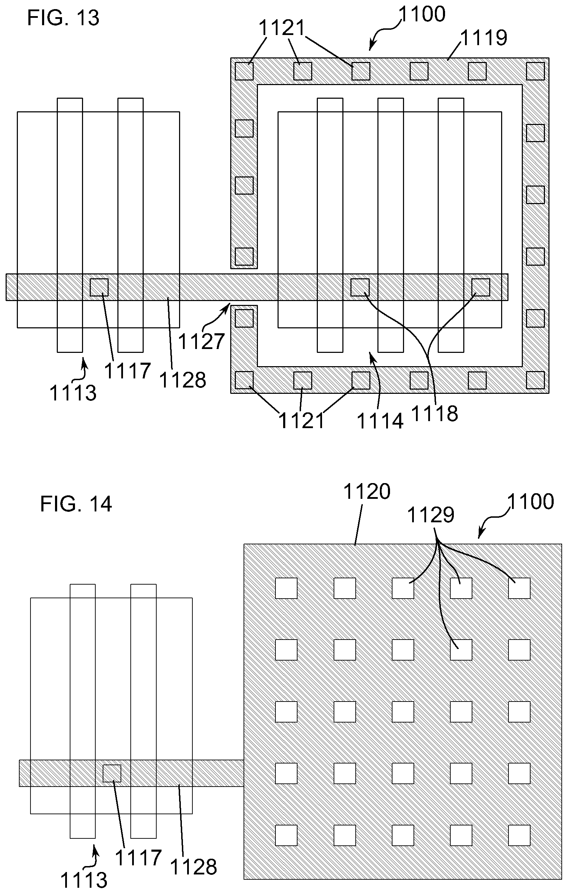

To allow for such interconnects, the rings of the electrically conductive connection lines 1119 include gaps, holes or openings (outside of the planes of the cross sections of FIGS. 11 and 12) through which other electrically conductive interconnect lines (also outside of the plane of the cross section) may be disposed. For example, the simplified layout view in FIG. 13 of a portion of the integrated circuit assembly 1100 shows one of the rings of the electrically conductive connection lines 1119 with an opening 1127 through which an electrically conductive interconnect line 1128 may be disposed, in accordance with some embodiments. The electrically conductive interconnect line 1128 generally connects the electrically conductive connection lines 1116 and the active devices 1114 inside the Faraday cage to the electrically conductive connection lines 1115 and the active devices 1113 outside the Faraday cage.

Each ring of the electrically conductive connection lines 1119 generally has one or more electrically conductive interconnect line (e.g., 1128) and one or more openings (e.g., 1127). The number of electrically conductive interconnect lines (e.g., 1128) and openings (e.g., 1127) is generally dependent on the need for electrical connections between the active devices 1114 inside the Faraday cage and the active devices 1113 outside the Faraday cage and any physical limitations for routing these electrical connections. In some embodiments, the physical limitations for routing these electrical connections may result in some of the rings of the electrically conductive connection lines 1119 not having an opening therein. Instead, the electrically conductive connection lines 1116 at the level of these rings may simply be used to route the electrical connections to a different electrically conductive interconnect layer (e.g., 1103, 1106, 1123 or 1125).

FIG. 13 also shows the electrically conductive vias 1121 arranged at appropriate intervals around the ring of the electrically conductive connection line 1119. The spacing for the electrically conductive vias 1121 and the size of the openings (e.g., 1127) is generally limited by the wavelength of the E/M radiation from electrical signals that the Faraday cage is expected to protect against. For example, for a signal frequency at about 10GHz or less, the wavelength is on the order of centimeters to millimeters. So a typical spacing of vias of less than 1 micron is sufficiently small enough to screen the E/M radiation due to such signals.

FIG. 14 illustrates that, in some embodiments, the plates of the electrically conductive connection lines 1120 may be perforated with holes 1129 to reduce capacitance to ground of the circuitry inside the Faraday cage. The size of the holes 1129 may be limited by the wavelength of the E/M radiation from electrical signals that the Faraday cage is expected to protect against. The plates of the electrically conductive connection lines 1120 may thus include various patterns of holes or pores. For example, the plates of the electrically conductive connection lines 1120 do not have to be solid layers and may include pores at irregular or regular locations. These patterns can advantageously reduce the parasitic capacitance of the plates of the electrically conductive connection lines 1120 while at the same time maintaining the efficacy of the plates of the electrically conductive connection lines 1120 in terms of its ability to screen the circuitry inside the Faraday cage from electromagnetic energy. For example, the plates of the electrically conductive connection lines 1120 could comprise a mesh having evenly spaced pores of circular or quadrilateral shape. The quadrilateral pores could be formed by intersecting strips of metallization laid out as a grid. In addition, the plates of the electrically conductive connection lines 1120 can include gaps for electrical conduits to pass through the plates of the electrically conductive connection lines 1120, e.g., electrically conductive vias that may extend from the electrically conductive connection lines 1116 inside the Faraday cage through the plates of the electrically conductive connection lines 1120 to the electrically conductive connection lines 1115 above or below the Faraday cage. To balance the efficacy of the plates of the electrically conductive connection lines 1120 against the allowance for electrically conductive vias to connect circuit elements on inside and outside the Faraday cage, the gaps for the electrically conductive vias can be designed to fit within a predetermined pattern of the plates of the electrically conductive connection lines 1120. For example, the electrically conductive vias could be formed through the pores of the plates of the electrically conductive connection lines 1120 that are already in use for limiting the parasitic capacitance of the plates of the electrically conductive connection lines 1120. As another example, the electrically conductive vias could be formed in a pattern that is removed from the immediate vicinity of the active devices 1114 inside the Faraday cage. The active devices 1114 inside the Faraday cage could be located in a central portion of the Faraday cage while the electrically conductive vias are aligned over a periphery of the plates of the electrically conductive connection lines 1120.

FIG. 14 illustrates one of the plates of the electrically conductive connection lines 1120 with a pattern of evenly spaced square holes 1129. The regularity of the pattern is not essential and is only included for illustrative purposes. The size of the square holes 1129 is set by the diagonal of the square. The efficacy of the plates of the electrically conductive connection lines 1120 can be maintained while decreasing the parasitic capacitance of the plates of the electrically conductive connection lines 1120 by controlling the size and pattern of the holes 1129.

The efficacy of the plates of the electrically conductive connection lines 1120 in relation to the size of the holes 1129 is set by the frequency of the electromagnetic interference that is being shielded. For example, at typical RF frequencies in the GHz range, holes with sizes on the order of microns can reduce parasitic capacitance while still effectively screening the active devices 1114 inside the Faraday cage from electromagnetic energy. In the context of electromagnetic interference propagating through a semiconductor device, wavelength can be expressed according to the following equation:

$$\lambda = \frac{c}{n \, f}$$

In this equation, $\lambda$ is wavelength, c is the speed of light, n is the refractive index of the material that is propagating the signal, and $f$ is the frequency. The relative refractive index of silicon dioxide, for example, is about 3.9. So the wavelength of a 1 GHz wave in silicon dioxide is about 7.5 cm. The attenuation provided by an aperture is calculated from the following equation:

$$A = 20 \log_{10} \left( \frac{\lambda}{2 \, s} \right)$$

In this equation, A is attenuation, $\lambda$ is wavelength, and the aperture size is s. According to this equation, the attenuation of an opening that is 1/10 the wavelength of the signal that is being attenuated is 14 decibels. An opening that is 1/1000 the wavelength of the signal that is being attenuated provides an attenuation of 54 decibles. Thus a 7.5 $\mu$m opening compared to a 7.5 cm wavelength, for example, gives an attenuation of 54 decibels. Thus the required attenuation can be used to determine the maximum size allowable for the holes 1129. In general, a ratio of 10% between the wavelength and the size of the holes 1129 will provide a suitable figure of merit for most RF applications. However, the exact ratio depends on the requirements for the overall RF system to which the semiconductor device is a part.

In some embodiments, portions of the integrated circuit assembly 1100 may be formed by the process described above with respect to FIGS. 3 and 4. For example, formation of the integrated circuit assembly 1100 may begin with an SOI structure having the semiconductor layer 1101, the insulating layer 1102, and a substrate layer (e.g., 210, FIG. 4A). The insulating layer 1102 has a first surface in contact with the semiconductor layer 1101 and a second surface in contact with the substrate (e.g., 210) below the first surface. The semiconductor layer 1101 has a first surface in contact with the insulating layer 1102 and a second surface 236 above the first surface. The insulating layer 1102 may be comprised of, for example, silicon dioxide, and it may be, for example, between 10 and 1000 nm thick, for example, between 15 and 70 nm thick, or between 150 and 350 nm thick, or between 500 and 750 nm thick. The semiconductor layer 1101 may be comprised of, for example, silicon, or a III-V semiconductor such as GaAs, or a strained semiconductor alloy such as SiGe.

Circuit elements, for example, the active devices 1113 and 1114, are formed in the semiconductor layer 1101. The active devices 1113 and 1114 comprise source regions (e.g., 240s, FIG. 4B), drain regions (e.g., 240d), and gate layers (e.g., 240g), and are separated by isolation regions (e.g., 232). These elements may be formed as described for step 120 in FIG. 3 above; that is, using, for example, a standard CMOS process, or a bi-polar-CMOS (BiCMOS) process. Other circuit elements may be formed in addition to, or instead of, CMOS transistors (e.g., 240), for example, high-power devices, optoelectronic devices, or other passive or reactive elements. In some embodiments, the electrically conductive ring of polysilicon 1122 may also be formed along with the source and drain regions of the active devices 1113 and 1114.

The inter-level dielectric layer 1108 is then formed over the active devices 1113 and 1114. The electrically conductive vias 1117, 1118, and 1121 are also formed through the inter-level dielectric layer 1108. The electrically conductive vias 1121 that form part of the Faraday cage may be formed down to the electrically conductive ring of polysilicon 1122 (if present) or down to any appropriate depth in the semiconductor layer 1101 or the insulating layer 1102.

The first front or top side electrically conductive interconnect layer 1103 may be formed (e.g., similar to the formation of the interconnect layer 250 above) optionally coupled to the second surface of the semiconductor layer 1101 (e.g., indirectly coupled through the inter-level dielectric layer 1108), and above the circuit elements (e.g., the active devices 1113 and 1114) fabricated therein. The electrically conductive connection lines 1115 and 1116 and the ring of the electrically conductive connection line 1119 of the electrically conductive interconnect layer 1103 are thus formed, with appropriate patterning, including the openings 1127 in the ring and the electrically conductive interconnect lines 1128 disposed through the openings 1127. The ring of the electrically conductive connection line 1119 thus surrounds a region of the electrically conductive interconnect layer 1103 above the region of the semiconductor layer 1101 containing the active devices 1114. The inter-level dielectric layer 1108 separates the electrically conductive interconnect layer 1103 from the active devices 1113 and 1114 formed in the semiconductor layer 1101.

The process for forming inter-layer dielectric layers, electrically conductive vias, and electrically conductive interconnect layers is repeated for as many electrically conductive interconnect layers (e.g., 1104, 1105, 1123, etc.) as are needed. All of the necessary front or top side rings of the electrically conductive connection lines 1119 and the front or top side plate of the electrically conductive connection line 1120 are thus formed. A layer 1130 (e.g., of insulation, passivation or bonding material) may optionally be placed over the topmost electrically conductive interconnect layer.

The handle wafer/layer 1112 (e.g., similar to handle layer 260 above) is coupled or bonded to the top or second surface of the semiconductor layer 1101, with the various inter-level dielectric layers (e.g., 1108-1110, 1124, etc.), the front or top side electrically conductive interconnect layers (e.g., 1103-1105, 1123, etc.), and the layer 1130 intervening. The handle wafer/layer 1112 may include a substrate 1131 and a bonding layer 1132. The bonding layer 1132, if needed, may be used to bond to the top or second surface of the wafer containing the semiconductor layer 1101. The handle wafer/layer 1112 is thus placed above all of the electrically conductive interconnect layers of the integrated circuit assembly 1100.

The handle wafer/layer 1112 is generally capable of providing sufficient strength for the integrated circuit assembly 1100 that the substrate (e.g., 210) is not needed. Therefore, as described above, the assembly is inverted and the substrate (e.g., 210) of the SOI structure is removed. This step exposes the bottom, back side or second surface of the insulating layer 1102.

Holes, as described above, are then etched through the insulating layer 1102 for the first bottom or back side electrically conductive vias 1117, 1118, and 1121. The holes for the electrically conductive vias 1121 for the Faraday cage may be etched to the electrically conductive ring of polysilicon 1122, to the first front or top side ring of the electrically conductive connection line 1119 or to the first front or top side electrically conductive vias 1121.

The first bottom or back side electrically conductive interconnect layer 1106 is formed on the second surface of the insulating layer 1102 and inside the holes for first bottom or back side electrically conductive vias 1117, 1118, and 1121. The process for forming inter-layer dielectric layers, electrically conductive vias, and electrically conductive interconnect layers is repeated for as many electrically conductive interconnect layers (e.g., 1106, 1107, 1125, etc.) as are needed. All of the necessary bottom or back side rings of the electrically conductive connection lines 1119 and the bottom or back side plate of the electrically conductive connection line 1120 (with or without the capacitance-reducing holes 1129) are thus formed. A layer 1133 (e.g., of insulation or passivation material) may optionally be placed over the bottommost electrically conductive interconnect layer.

Since the handle wafer/layer 1112 is added after the front or top side electrically conductive interconnect layers (e.g., 1103-1105, 1123, etc.) have been formed, and since the substrate (e.g., 210) of the original SOI structure is removed, all of the electrically conductive interconnect layers (e.g., metallization or conductive polysilicon) are located on one side of the overall wafer, or the integrated circuit assembly 1100. Thus, no metallization on the exposed side of the handle wafer/layer 1112 is required. In other words, all metal or electrically conductive connection lines are on one side of the wafer. This feature is advantageous because the final wafer can be thinned at the end of processing to any desired thickness by thinning the substrate 1131 of the handle wafer/layer 1112. Also, die handling is simpler, because if metal were present on the back of the die, care would have to be taken not to scratch the back side metal during wafer and die handling. Also, if the singulated die were placed on a package with a metal leadframe, all back side metal would be shorted to the same potential, thereby reducing flexibility of circuit design.

Additionally, in the integrated circuit assembly 1100, since the substrate (e.g., 210) of the original SOI structure is removed, the material contained inside the Faraday cage is substantially or primarily composed of the active structures, with a minimum of other or additional material. Very little, if any, semiconductor substrate material is included within the Faraday cage. The mechanical substrate 1131 that provides the structural integrity of the resulting chip is outside the Faraday cage. Additionally, the insulating layer 1102 may optionally be thinned in some embodiments. In this manner, the volume or size of the Faraday cage is minimized, thereby minimizing the exposure of the contained structures to external E/M influences.

Additionally, in the integrated circuit assembly 1100, no metallization passes through a semiconductor substrate. Therefore, the formation of the vias and interconnects is relatively simple.

Furthermore, in the integrated circuit assembly 1100, no TSVs (i.e., through silicon/semiconductor vias) are required. TSV structures usually have large design rules because they extend for many microns through the mechanical substrate. Without TSVs, however, smaller volumes of material can be contained in separate Faraday cages.

Additionally, in the integrated circuit assembly 1100, no portion of a packaging is required to form any part of the Faraday cage. Instead, the Faraday cage is fully integrated into the chip or die, so any appropriate packaging design can be used.

The back-side interconnect processes described herein are applicable to many different types of SOI fabrication processes, for example, fully-depleted or partially-depleted SOI processes. Also, multiple layers of metal interconnect may be used on the front or back side of the transferred layer, by, for example, repeating the applicable steps described herein.

**Claims**

1. An integrated circuit assembly (1100) comprising:

   an insulating layer (1102) having a first surface and a second surface, the second surface being below the first surface;
   a semiconductor layer (1101) having a first surface and a second surface, the first surface of the semiconductor layer contacting the first surface of the insulating layer;
   an active device (1114) formed in a region of the semiconductor layer;
   a first electrically conductive interconnect layer (1103) forming an electrically conductive ring (1119);
   a second electrically conductive interconnect layer (1104) forming a first electrically conductive plate (1120) above the electrically conductive ring (1119) and the region of the semiconductor layer in which the active device is formed;
   a third electrically conductive interconnect layer (1107) forming a second electrically conductive plate (1120) below i) the electrically conductive ring (1119), ii) the insulating layer, and iii) the region of the semiconductor layer in which the active device is formed; and
   a plurality of electrically conductive vias (1121) electrically coupling the electrically conductive ring (1119) to the first electrically conductive plate (1120) through one or more dielectric layers (1109) located between the first electrically conductive interconnect layer (1103) and the second electrically conductive interconnect layer (1104) and electrically coupling the electrically conductive ring (1119) to the second electrically conductive plate (1120) through one or more dielectric layers (1108, 1111, 1126) located between the first electrically conductive interconnect layer (1103) and the third electrically conductive interconnect layer (1107);
   wherein the electrically conductive ring (1119), the first electrically conductive plate (1120), the second electrically conductive plate (1120), and the plurality of electrically conductive vias (1121) form a Faraday cage around the active device (1114).

2. The integrated circuit assembly of claim 1, wherein: the electrically conductive ring (1119) surrounds a region above the region of the semiconductor layer.

3. The integrated circuit assembly of claim 1, wherein:

   the electrically conductive ring (1119) comprises an opening (1127) therein;
   the first electrically conductive interconnect layer further comprises an electrically conductive connection line (1128) disposed through the opening in the electrically conductive ring; and
   the electrically conductive connection line electrically connects the first active device (1114) to a second active device (1113) in a second region of the semiconductor layer outside the Faraday cage.

4. The integrated circuit assembly of claim 1, further comprising:

   a fourth electrically conductive interconnect layer (1123) connected to the second surface of the insulating layer and forming a second electrically conductive ring around a sub- insulator region below the region of the semiconductor layer;
   wherein:

the first electrically conductive interconnect layer is located above the second surface of the semiconductor layer;

the first electrically conductive ring surrounds an upper region above the region of the semiconductor layer;

the plurality of electrically conductive vias electrically couples the first electrically conductive ring to the second electrically conductive plate through the second electrically conductive ring; and

the first electrically conductive ring, the first electrically conductive plate, the second electrically conductive plate, the second electrically conductive ring, and the plurality of electrically conductive vias form the Faraday cage around the active device.

5. The integrated circuit assembly of claim 4, wherein:

the second electrically conductive ring comprises an opening therein;

the fourth electrically conductive interconnect layer (1123) further comprises an electrically conductive connection line disposed through the opening in the second electrically conductive ring; and

the electrically conductive connection line electrically connects the first active device to a second active device in a second region of the semiconductor layer outside the Faraday cage.

6. The integrated circuit assembly of claim 4, further comprising:

a fifth electrically conductive interconnect layer (1125) forming a third electrically conductive ring between the first electrically conductive ring and the first electrically conductive plate; wherein:

the plurality of electrically conductive vias electrically couples the first electrically conductive ring to the first electrically conductive plate through the third electrically conductive ring; and

the first electrically conductive ring, the first electrically conductive plate, the second electrically conductive plate, the second electrically conductive ring, the third electrically conductive ring, and the plurality of electrically conductive vias form the Faraday cage around the active device.

7. The integrated circuit assembly of claim 6, further comprising:

a sixth electrically conductive interconnect layer forming a fourth electrically conductive ring between the second electrically conductive ring and the second electrically conductive plate; wherein:

the plurality of electrically conductive vias electrically couples the second electrically conductive ring to the second electrically conductive plate through the fourth electrically conductive ring; and

the first electrically conductive ring, the first electrically conductive plate, the second electrically conductive plate, the second electrically conductive ring, the third electrically conductive ring, the fourth electrically conductive ring, and the plurality of electrically conductive vias form the Faraday cage around the active device.

8. The integrated circuit assembly of claim 1, wherein: the first electrically conductive plate (1120) and the second electrically conductive plate (1120) are perforated with a set of holes (1129) that reduce a capacitance to ground of the active device.

9. The integrated circuit assembly of claim 1, further comprising:

a second electrically conductive ring (1122) surrounding the region of the semiconductor layer and consisting of polysilicon; wherein:

the plurality of electrically conductive vias (1121) also electrically couple the first electrically conductive ring (1119) to the second electrically conductive ring (1122); wherein the first electrically conductive ring, the first electrically conductive plate, the second electrically conductive plate, the second electrically conductive ring, and the plurality of electrically conductive vias form the Faraday cage around the active device.

10. The integrated circuit assembly of claim 1, further comprising: a bonded handle wafer (1112) having a substrate above all of the electrically conductive interconnect layers.

11. A method comprising:

providing a semiconductor wafer having an insulating layer, a semiconductor layer, and a substrate layer, the insulating layer having a first surface and a second surface, the second surface of the insulating layer being below the first surface of the insulating layer, the substrate layer contacting the second surface of the insulating layer, the semiconductor layer having a first surface and a second surface, the first surface of the semiconductor layer contacting the first surface of the insulating layer;
forming an active device in a region of the semiconductor layer;
forming a first electrically conductive interconnect layer with an electrically conductive ring;
forming a second electrically conductive interconnect layer with a first electrically conductive plate above the electrically conductive ring and the region of the semiconductor layer, the second electrically conductive interconnect layer being formed with a first dielectric layer between the first electrically conductive interconnect layer and the second electrically conductive interconnect layer;
removing the substrate layer from the second surface of the insulating layer;
forming a third electrically conductive interconnect layer with a second electrically conductive plate below i) the electrically conductive ring, ii) the insulating layer, and iii) the region of the semiconductor layer in which the active device is formed, the third electrically conductive interconnect layer being formed with a second dielectric layer between the first electrically conductive interconnect layer and the third electrically conductive interconnect layer; and
forming a plurality of electrically conductive vias electrically coupling the electrically conductive ring to the first electrically conductive plate through the first dielectric layer and to the second electrically conductive plate through the second dielectric layer;
wherein the electrically conductive ring, the first electrically conductive plate, the second electrically conductive plate, and the plurality of electrically conductive vias form a Faraday cage around the active device.

12. The method of claim 11, further comprising:

forming a second active device in a second region of the semiconductor layer outside the Faraday cage;
forming an opening in the electrically conductive ring; and
forming an electrically conductive connection line disposed through the opening in the electrically conductive ring;
wherein the electrically conductive connection line electrically connects the first active device to the second active device.

13. The method of claim 11, further comprising:

forming the first electrically conductive interconnect layer coupled to the second surface of the semiconductor layer with the first electrically conductive ring around a region above the region of the semiconductor layer;
forming a fourth electrically conductive interconnect layer coupled to the second surface of the insulating layer with a second electrically conductive ring around a region below the region of the semiconductor layer;
wherein:

the plurality of electrically conductive vias electrically couples the first electrically conductive ring to the second electrically conductive plate through the second electrically conductive ring; and
the first electrically conductive ring, the first electrically conductive plate, the second electrically conductive plate, the second electrically conductive ring, and the plurality of electrically conductive vias form the Faraday cage around the active device.

14. The method of claim 11, further comprising:
forming the first electrically conductive plate and the second electrically conductive plate with a set of holes that reduce a capacitance to ground of the active device.

15. The method of claim 11, further comprising:

forming a second electrically conductive ring of polysilicon around the region of the semiconductor layer;
wherein:

the plurality of electrically conductive vias also electrically couple the first electrically conductive ring to the second electrically conductive ring;
wherein the first electrically conductive ring, the first electrically conductive plate, the second electrically conductive plate, the second electrically conductive ring, and the plurality of electrically conductive vias form the Faraday cage around the active device.

**Patentansprüche**

1. Integrierte Schaltungsbaugruppe (1100), die Folgendes umfasst:

eine Isolierschicht (1102) mit einer ersten Oberfläche und einer zweiten Oberfläche, wobei sich die zweite Oberfläche unterhalb der ersten Oberfläche befindet;

eine Halbleiterschicht (1101) mit einer ersten Oberfläche und einer zweiten Oberfläche, wobei die erste Oberfläche der Halbleiterschicht mit der ersten Oberfläche der Isolierschicht in Kontakt ist;

ein aktives Bauelement (1114), das in einer Region der Halbleiterschicht ausgebildet ist;

eine erste elektrisch leitfähige Verbindungsschicht (1103), die einen elektrisch leitfähigen Ring (1119) bildet;

eine zweite elektrisch leitfähige Verbindungsschicht (1104), die eine erste elektrisch leitfähige Platte (1120) über dem elektrisch leitfähigen Ring (1119) und der Region der Halbleiterschicht bildet, in der das aktive Bauelement ausgebildet ist;

eine dritte elektrisch leitfähige Verbindungsschicht (1107), die eine zweite elektrisch leitfähige Platte (1120) unterhalb von i) dem elektrisch leitfähigen Ring (1119), ii) der Isolierschicht und iii) der Region der Halbleiterschicht bildet, in der das aktive Bauelement ausgebildet ist; und

mehrere elektrisch leitfähige Durchkontaktierungen (1121), die den elektrisch leitfähigen Ring (1119) mit der ersten elektrisch leitfähigen Platte (1120) durch eine oder mehrere dielektrische Schichten (1109) koppeln, die sich zwischen der ersten elektrisch leitfähigen Verbindungsschicht (1103) und der zweiten elektrisch leitfähigen Verbindungsschicht (1104) befinden, und den elektrisch leitfähigen Ring (1119) mit der zweiten elektrisch leitfähigen Platte (1120) durch eine oder mehrere dielektrische Schichten (1108, 1111, 1126) koppeln, die sich zwischen der ersten elektrisch leitfähigen Verbindungsschicht (1103) und der dritten elektrisch leitfähigen Verbindungsschicht (1107) befinden;

wobei der elektrisch leitfähige Ring (1119), die erste elektrisch leitfähige Platte (1120), die zweite elektrisch leitfähige Platte (1120) und die mehreren elektrisch leitfähigen Durchkontaktierungen (1121) einen Faradaykäfig um das aktive Bauelement (1114) herum bilden.

2.   Integrierte Schaltungsbaugruppe nach Anspruch 1, wobei:

der elektrisch leitfähige Ring (1119) eine Region über der Region der Halbleiterschicht umgibt.

3.   Integrierte Schaltungsbaugruppe nach Anspruch 1, wobei:

der elektrisch leitfähige Ring (1119) eine Öffnung (1127) darin aufweist;

die erste elektrisch leitfähige Verbindungsschicht ferner eine elektrisch leitfähige Verbindungsleitung (1128) umfasst, die durch die Öffnung in dem elektrisch leitfähigen Ring angeordnet ist; und

die elektrisch leitfähige Verbindungsleitung das erste aktive Bauelement (1114) mit einem zweiten aktiven Bauelement (1113) in einer zweiten Region der Halbleiterschicht außerhalb des Faradaykäfigs verbindet.

4.   Integrierte Schaltungsbaugruppe nach Anspruch 1, die ferner Folgendes umfasst:

eine vierte elektrisch leitfähige Verbindungsschicht (1123), die mit der zweiten Oberfläche der Isolierschicht verbunden ist und einen zweiten elektrisch leitfähigen Ring um eine Subisolatorregion herum unterhalb der Region der Halbleiterschicht ausbildet;

wobei:

die erste elektrisch leitfähige Verbindungsschicht sich über der zweiten Oberfläche der Halbleiterschicht befindet;

der erste elektrisch leitfähige Ring eine obere Region über der Region der Halbleiterschicht umgibt;

die mehreren elektrisch leitfähigen Durchkontaktierungen den ersten elektrisch leitfähigen Ring elektrisch mit der zweiten elektrisch leitfähigen Platte durch den zweiten elektrisch leitfähigen Ring koppeln; und

der erste elektrisch leitfähige Ring, die zweite elektrisch leitfähige Platte, die zweite elektrisch leitfähige Platte, der zweite elektrisch leitfähige Ring und die mehreren elektrisch leitfähigen Kontaktierungen den Faradaykäfig um das aktive Bauelement herum bilden.

5.   Integrierte Schaltungsbaugruppe nach Anspruch 4, wobei:

der zweite elektrisch leitfähige Ring eine Öffnung darin aufweist;

die vierte elektrisch leitfähige Verbindungsschicht (1123) ferner eine elektrisch leitfähige Verbindungsleitung umfasst, die durch die Öffnung in dem zweiten elektrisch leitfähigen Ring herum angeordnet ist; und

die elektrisch leitfähige Verbindungsleitung das erste aktive Bauelement elektrisch mit einem zweiten aktiven Bauelement in einer zweiten Region der Halbleiterschicht außerhalb des Faradaykäfigs verbindet.

6.   Integrierte Schaltungsbaugruppe nach Anspruch 4, die ferner Folgendes umfasst:

eine fünfte elektrisch leitfähige Verbindungsschicht (1125), die einen dritten elektrisch leitfähigen Ring zwischen dem ersten elektrisch leitfähigen Ring und der ersten elektrisch leitfähigen Platte bildet;
wobei:

die mehreren elektrisch leitfähigen Durchkontaktierungen den ersten elektrisch leitfähigen Ring elektrisch mit der ersten elektrisch leitfähigen Platte durch den dritten elektrisch leitfähigen Ring koppeln; und
der erste elektrisch leitfähige Ring, die erste elektrisch leitfähige Platte, die zweite elektrisch leitfähige Platte, der zweite elektrisch leitfähige Ring, der dritte elektrisch leitfähige Ring und die mehreren elektrisch leitfähigen Durchkontaktierungen den Faradaykäfig um das aktive Bauelement herum bilden.

7. Integrierte Schaltungsbaugruppe nach Anspruch 6, die ferner Folgendes umfasst:

eine sechste elektrisch leitfähige Verbindungsschicht, die einen vierten elektrisch leitfähigen Ring zwischen dem zweiten elektrisch leitfähigen Ring und der zweiten elektrisch leitfähigen Platte bildet;
wobei:

die mehreren elektrisch leitfähigen Durchkontaktierungen den zweiten elektrisch leitfähigen Ring elektrisch mit der zweiten elektrisch leitfähigen Platte durch den vierten elektrisch leitfähigen Ring koppeln; und
der erste elektrisch leitfähige Ring, die erste elektrisch leitfähige Platte, die zweite elektrisch leitfähige Platte, der zweite elektrisch leitfähige Ring, der dritte elektrisch leitfähige Ring, der vierte elektrisch leitfähige Ring und die mehreren elektrisch leitfähigen Durchkontaktierungen den Faradaykäfig um das aktive Bauelement herum bilden.

8. Integrierte Schaltungsbaugruppe nach Anspruch 1, wobei:

die erste elektrisch leitfähige Platte (1120) und die zweite elektrisch leitfähige Platte (1120) mit einem Satz von Löchern (1129) perforiert sind, die eine Kapazität gegen Masse des aktiven Bauelements reduzieren.

9. Integrierte Schaltungsbaugruppe nach Anspruch 1, die ferner Folgendes umfasst:

einen zweiten elektrisch leitfähigen Ring (1122), der die Region der Halbleiterschicht umgibt und aus Polysilicium besteht;
wobei:

die mehreren elektrisch leitfähigen Durchkontaktierungen (1121) auch den ersten elektrisch leitfähigen Ring (1119) elektrisch mit dem zweiten elektrisch leitfähigen Ring (1122) koppeln;
wobei der erste elektrisch leitfähige Ring, die erste elektrisch leitfähige Platte, die zweite elektrisch leitfähige Platte, der zweite elektrisch leitfähige Ring und die mehreren elektrisch leitfähigen Durchkontaktierungen den Faradaykäfig um das aktive Bauelement herum bilden.

10. Integrierte Schaltungsbaugruppe nach Anspruch 1, die ferner Folgendes umfasst:
einen gebondeten Handle-Wafer (1112) mit einem Subtrat über allen elektrisch leitfähigen Verbindungsschichten.

11. Verfahren, das Folgendes beinhaltet:

Bereitstellen eines Halbleiterwafers mit einer Isolierschicht, einer Halbleiterschicht und einer Substratschicht, wobei die Isolierschicht eine erste Oberfläche und eine zweite Oberfläche hat, wobei sich die zweite Oberfläche der Isolierschicht unterhalb der ersten Oberfläche der Isolierschicht befindet, wobei die Substratschicht mit der zweiten Oberfläche der Isolierschicht in Kontakt ist, wobei die Halbleiterschicht eine erste Oberfläche und eine zweite Oberfläche aufweist, wobei die erste Oberfläche der Halbleiterschicht mit der ersten Oberfläche der Isolierschicht in Kontakt ist;
Ausbilden eines aktiven Bauelements in einer Region der Halbleiterschicht;
Ausbilden einer ersten elektrisch leitfähigen Verbindungsschicht mit einem elektrisch leitfähigen Ring;
Ausbilden einer zweiten elektrisch leitfähigen Verbindungsschicht mit einer ersten elektrisch leitfähigen Platte über dem elektrisch leitfähigen Ring und der Region der Halbleiterschicht, wobei die zweite elektrisch leitfähige Verbindungsschicht mit einer ersten dielektrischen Schicht zwischen der ersten elektrisch leitfähigen Verbindungsschicht und der zweiten elektrisch leitfähigen Verbindungsschicht ausgebildet ist;
Entfernen der Substratschicht von der zweiten Oberfläche der Isolierschicht;
Ausbilden einer dritten elektrisch leitfähigen Verbindungsschicht mit einer zweiten elektrisch leitfähigen Platte unterhalb i) dem elektrisch leitfähigen Ring, ii) der Isolierschicht und iii) der Region der Halbleiterschicht, in der das aktive Bauelement ausgebildet ist, wobei die dritte elektrisch leitfähige Verbindungsschicht mit einer zweiten dielektrischen Schicht zwischen der ersten elektrisch leitfähigen Verbindungsschicht und der dritten elektrisch leitfähigen Verbindungsschicht ausgebildet ist; und

Ausbilden der mehreren elektrisch leitfähigen Durchkontaktierungen, die den elektrisch leitfähigen Ring elektrisch mit der ersten elektrisch leitfähigen Platte durch die erste dielektrische Schicht und mit der zweiten elektrisch leitfähigen Platte durch die zweite dielektrische Schicht koppeln;

wobei der elektrisch leitfähige Ring, die erste elektrisch leitfähige Platte, die zweite elektrisch leitfähige Platte und die mehreren elektrisch leitfähigen Durchkontaktierungen einen Faradaykäfig um das aktive Bauelement herum bilden.

12. Verfahren nach Anspruch 11, das ferner Folgendes beinhaltet:

Ausbilden eines zweiten aktiven Bauelements in einer zweiten Region der Halbleiterschicht außerhalb des Faradaykäfigs;
Ausbilden einer Öffnung in dem elektrisch leitenden Ring; und
Ausbilden einer elektrisch leitfähigen Verbindungsleitung, die durch die Öffnung in dem elektrisch leitfähigen Ring angeordnet ist;
wobei die elektrisch leitfähige Verbindungsleitung das erste aktive Bauelement elektrisch mit dem zweiten aktiven Bauelement verbindet.

13. Verfahren nach Anspruch 11, das ferner Folgendes beinhaltet:

Ausbilden der mit der zweiten Oberfläche der Halbleiterschicht gekoppelten ersten elektrisch leitfähigen Verbindungsschicht mit dem ersten elektrisch leitfähigen Ring um eine Region über der Region der Halbleiterschicht;
Ausbilden einer mit der zweiten Oberfläche der Isolierschicht gekoppelten vierten elektrisch leitfähigen Verbindungsschicht mit einem zweiten elektrisch leitfähigen Ring um eine Region unterhalb der Region der Halbleiterschicht;
wobei:

die mehreren elektrisch leitfähigen Durchkontaktierungen den ersten elektrisch leitfähigen Ring elektrisch mit der zweiten elektrisch leitfähigen Platte durch den vierten elektrisch leitfähigen Ring koppeln; und
der erste elektrisch leitfähige Ring, die erste elektrisch leitfähige Platte, die zweite elektrisch leitfähige Platte, der zweite elektrisch leitfähige Ring und die mehreren elektrisch leitfähigen Durchkontaktierungen den Faradaykäfig um das aktive Bauelement herum bilden.

14. Verfahren nach Anspruch 11, das ferner Folgendes beinhaltet:
Ausbilden der ersten elektrisch leitfähigen Platte und der zweiten elektrisch leitfähigen Platte mit einem Satz von Löchern, die eine Kapazität gegen Masse des aktiven Bauelements reduzieren.

15. Verfahren nach Anspruch 11, das ferner Folgendes beinhaltet:

Ausbilden eines zweiten elektrisch leitfähigen Rings aus Polysilicium um die Region der Halbleiterschicht;
wobei:

die mehreren elektrisch leitfähigen Durchkontaktierungen auch den ersten elektrisch leitfähigen Ring elektrisch mit dem zweiten elektrisch leitfähigen Ring koppeln;
wobei der erste elektrisch leitfähige Ring, die erste elektrisch leitfähige Platte, die zweite elektrisch leitfähige Platte, der zweite elektrisch leitfähige Ring und die mehreren elektrisch leitfähigen Durchkontaktierungen den Faradaykäfig um das aktive Bauelement herum bilden.

**Revendications**

1. Ensemble de circuit intégré (1100) comprenant :

une couche isolante (1102) présentant une première surface et une seconde surface, la seconde surface étant située en dessous de la première surface ;
une couche semi-conductrice (1101) présentant une première surface et une seconde surface, la seconde surface de la couche semi-conductrice faisant contact avec la première surface de la couche isolante ;
un dispositif actif (1114) formé dans une région de la couche semi-conductrice ;
une première couche d'interconnexion électriquement conductrice (1103) formant un anneau électriquement conducteur (1119) ;
une deuxième couche d'interconnexion électriquement conductrice (1104) formant une première plaque électriquement conductrice (1120) au-dessus de l'anneau électriquement conducteur (1119) et de la région de la couche semi-conductrice dans laquelle le dispositif actif est formé ;

une troisième couche d'interconnexion électriquement conductrice (1107) formant une seconde plaque électriquement conductrice (1120) en dessous i) de l'anneau électriquement conducteur (1119), ii) de la couche isolante, e iii) de la région de la couche semi-conductrice dans laquelle le dispositif actif est formé ; et

une pluralité de trous d'interconnexion électriquement conducteurs (1121) qui couplent électriquement l'anneau électriquement conducteur (1119) à la première plaque électriquement conductrice (1120) par le biais d'une ou de plusieurs couches diélectriques (1109) situées entre la première couche d'interconnexion électriquement conductrice (1103) et la deuxième couche d'interconnexion électriquement conductrice (1104) et couplent électriquement l'anneau électriquement conducteur (1119) à la seconde plaque électriquement conductrice (1120) par le biais d'une ou de plusieurs couches diélectriques (1108, 1111, 1126) situées entre la première couche d'interconnexion électriquement conductrice (1103) et la troisième couche d'interconnexion électriquement conductrice (1107) ;

dans lequel l'anneau électriquement conducteur (1119), la première plaque électriquement conductrice (1120), la seconde plaque électriquement conductrice (1120), et la pluralité de trous d'interconnexion électriquement conducteurs (1121) forment une cage de Faraday autour du dispositif actif (1114).

2. Ensemble de circuit intégré selon la revendication 1, dans lequel :
l'anneau électriquement conducteur (1119) entoure une région au-dessus de la région de la couche semi-conductrice.

3. Ensemble de circuit intégré selon la revendication 1, dans lequel :

l'anneau électriquement conducteur (1119) comprend une ouverture (1127) ;
la première couche d'interconnexion électriquement conductrice comprend en outre une ligne de connexion électriquement conductrice (1128) disposée à travers l'ouverture dans l'anneau électriquement conducteur ; et
la ligne de connexion électriquement conductrice connecte électriquement le premier dispositif actif (1114) à un second dispositif actif (1113) dans une seconde région de la couche semi-conductrice en dehors de la cage de Faraday.

4. Ensemble de circuit intégré selon la revendication 1, comprenant en outre :

une quatrième couche d'interconnexion électriquement conductrice (1123) connectée à la seconde surface de la couche isolante et formant un deuxième anneau électriquement conducteur autour d'une sous-région isolante en dessous de la région de la couche semi-conductrice ;
dans lequel :

la première couche d'interconnexion électriquement conductrice est située au-dessus de la seconde surface de la couche semi-conductrice ;
la premier anneau électriquement conducteur entoure une région supérieure au-dessus de la région de la couche semi-conductrice ;
la pluralité de trous d'interconnexion électriquement conducteurs couple électriquement le premier anneau électriquement conducteur à la seconde plaque électriquement conductrice par le biais du deuxième anneau électriquement conducteur ; et
le premier anneau électriquement conducteur, la première plaque électriquement conductrice, la seconde plaque électriquement conductrice, le deuxième anneau électriquement conducteur, et la pluralité de trous d'interconnexion électriquement conducteurs forment la cage de Faradays autour du dispositif actif.

5. Ensemble de circuit intégré selon la revendication 4, dans lequel :

le deuxième anneau électriquement conducteur comprend une ouverture ;
la quatrième couche d'interconnexion électriquement conductrice (1123) comprend en outre une ligne de connexion électriquement conductrice disposée à travers l'ouverture dans le deuxième anneau électriquement conducteur ; et
la ligne de connexion électriquement conductrice connecte électriquement le premier dispositif actif à un second dispositif actif dans une seconde région de la couche semi-conductrice en dehors de la cage de Faraday.

6. Ensemble de circuit intégré selon la revendication 4, comprenant en outre :

une cinquième couche d'interconnexion électriquement conductrice (1125) formant un troisième anneau électriquement conducteur entre le premier anneau électriquement conducteur et la première plaque électriquement conductrice ;
dans lequel :

la pluralité de trous d'interconnexion électriquement conducteurs couple électriquement le premier anneau électriquement conducteur à la première plaque électriquement conductrice par le biais d'un troisième anneau électriquement conducteur ; et

le premier anneau électriquement conducteur, la première plaque électriquement conductrice, la seconde plaque électriquement conductrice, le deuxième anneau électriquement conducteur, le troisième anneau électriquement conducteur, et la pluralité de trous d'interconnexion électriquement conducteurs forment la cage de Faraday autour du dispositif actif.

7. Ensemble de circuit intégré selon la revendication 6, comprenant en outre :

une sixième couche d'interconnexion électriquement conductrice formant un quatrième anneau électriquement conducteur entre le deuxième anneau électriquement conducteur et la seconde plaque électriquement conductrice ; dans lequel :

la pluralité de trous d'interconnexion électriquement conducteurs couple électriquement le deuxième anneau électriquement conducteur à la seconde plaque électriquement conductrice par le biais du quatrième anneau électriquement conducteur ; et

le premier anneau électriquement conducteur, la première plaque électriquement conductrice, la seconde plaque électriquement conductrice, le deuxième anneau électriquement conducteur, le troisième anneau électriquement conducteur, le quatrième anneau électriquement conducteur, et la pluralité de trous d'interconnexion électriquement conducteurs forment la cage de Faraday autour du dispositif actif.

8. Ensemble de circuit intégré selon la revendication 1, dans lequel :
la première plaque électriquement conductrice (1120) et la seconde plaque électriquement conductrice (1120) sont perforées par un ensemble de trous (1129) qui réduisent une capacité à la terre du dispositif actif.

9. Ensemble de circuit intégré selon la revendication 1, comprenant en outre :

un deuxième anneau électriquement conducteur (1122) qui entoure la région de la couche semi-conductrice et consiste en polysilicium ; dans lequel :

la pluralité de trous d'interconnexion électriquement conducteurs (1121) couple aussi électriquement le premier anneau électriquement conducteur (1119) au deuxième anneau électriquement conducteur (1122) ;

dans lequel le premier anneau électriquement conducteur, la première plaque électriquement conductrice, la seconde plaque électriquement conductrice, le deuxième anneau électriquement conducteur, et la pluralité de trous d'interconnexion électriquement conducteurs forment la cage de Faraday autour du dispositif actif.

10. Ensemble de circuit intégré selon la revendication 1, comprenant en outre :
une tranche de manipulation liée (1112) présentant un substrat au-dessus de toutes les couches d'interconnexion électriquement conductrices.

11. Procédé comprenant :

la fourniture d'une tranche semi-conductrice comportant une couche isolante, une couche semi-conductrice, et une couche de substrat, la couche isolante présentant une première surface et une seconde surface, la seconde surface de la couche isolante étant située en dessous de la première surface de la couche isolante, la couche de substrat faisant contact avec la seconde surface de la couche isolante, la couche semi-conductrice présentant une première surface et une seconde surface, la première surface de la couche semi-conductrice faisant contact avec la première surface de la couche isolante ;
la formation d'un dispositif actif dans une région de la couche semi-conductrice ;
la formation d'une première couche d'interconnexion électriquement conductrice avec un anneau électriquement conducteur ;
la formation d'une deuxième couche d'interconnexion électriquement conductrice avec une première plaque électriquement conductrice au-dessus de l'anneau électriquement conducteur et de la région de la couche semi-conductrice, la deuxième couche d'interconnexion électriquement conductrice étant formée avec une première couche diélectrique entre la première couche d'interconnexion électriquement conductrice et la deuxième couche d'interconnexion électriquement conductrice ;
l'élimination de la couche de substrat sur la seconde surface de la couche isolante ;
la formation d'une troisième couche d'interconnexion électriquement conductrice avec une seconde plaque électriquement conductrice en dessous de i) l'anneau électriquement conducteur, ii) la couche isolante, et iii) la région de la couche semi-conductrice dans laquelle le dispositif actif est formé, la troisième couche d'interconnexion électriquement conductrice étant formée avec une seconde couche diélectrique entre la première couche d'interconnexion électriquement conductrice et la troisième couche d'interconnexion électriquement conductrice ; et

la formation d'une pluralité de trous d'interconnexion électriquement conducteurs qui couplent électriquement l'anneau électriquement conducteur à la première plaque électriquement conductrice par le biais de la première couche diélectrique et à la seconde plaque électriquement conductrice par le biais de la seconde couche diélectrique ;

dans lequel l'anneau électriquement conducteur, la première plaque électriquement conductrice, la seconde plaque électriquement conductrice, et la pluralité de trous d'interconnexion électriquement conducteurs forment une cage de Faraday autour du dispositif actif.

12. Procédé selon la revendication 11, comprenant en outre :

la formation d'un second dispositif actif dans une seconde région de la couche semi-conductrice en dehors de la cage de Faraday ; la formation d'une ouverture dans l'anneau électriquement conducteur ; et la formation d'une ligne de connexion électriquement conductrice disposée à travers l'ouverture dans l'anneau électriquement conducteur ; dans lequel la ligne de connexion électriquement conductrice connecte électriquement le premier dispositif actif au second dispositif actif.

13. Procédé selon la revendication 11, comprenant en outre :

la formation de la première couche d'interconnexion électriquement conductrice couplée à la seconde surface de la couche semi-conductrice avec le premier anneau électriquement conducteur autour d'une région au-dessus de la région de la couche semi-conductrice ; la formation d'une quatrième couche d'interconnexion électriquement conductrice couplée à la seconde surface de la couche isolante avec un deuxième anneau électriquement conducteur autour d'une région en dessous de la région de la couche semi-conductrice ; dans lequel :

la pluralité de trous d'interconnexion électriquement conducteurs couple électriquement le premier anneau électriquement conducteur à la seconde plaque électriquement conductrice par le biais du deuxième anneau électriquement conducteur ; et le premier anneau électriquement conducteur, la première plaque électriquement conductrice, la seconde plaque électriquement conductrice, le deuxième anneau électriquement conducteur, et la pluralité de trous d'interconnexion électriquement conducteurs forment la cage de Faraday autour du dispositif actif.

14. Procédé selon la revendication 11, comprenant en outre :
la formation de la première plaque électriquement conductrice et de la seconde plaque électriquement conductrice avec un ensemble de trous qui réduisent une capacité à la terre du dispositif actif.

15. Procédé selon la revendication 11, comprenant en outre :

la formation d'un deuxième anneau électriquement conducteur de polysilicium autour de la région de la couche semi-conductrice ; dans lequel :

la pluralité de trous d'interconnexion électriquement conducteurs couple aussi électriquement le premier anneau électriquement conducteur au deuxième anneau électriquement conducteur ; dans lequel le premier anneau électriquement conducteur, la première plaque électriquement conductrice, la seconde plaque électriquement conductrice, le deuxième anneau électriquement conducteur, et la pluralité de trous d'interconnexion électriquement conducteurs forment la cage de Faraday autour du dispositif actif.

FIG. 1 Prior art

FIG. 2 Prior art

START

Provide a semiconductor-on-insulator including an insulator layer between a semiconductor layer and a substrate layer. — 110

100

Form active or reactive circuit elements in the semiconductor layer. — 120

OPTIONAL: form a metal interconnect layer above the semiconductor layer — 130

Couple the semiconductor layer to a handle layer — 140

Remove the substrate layer — 150

Form a hole that extends through the insulator layer, exposing the semiconductor layer (optional: simultaneously form a second hole that extends to the gate layer, or the interconnect layer above the semiconductor layer) — 160

OPTIONAL: extend the hole into the semiconductor layer, exposing a layer of metal-semiconductor compound — 170

Form a metal interconnect layer on the insulator layer and inside the holes in the insulator layer, electrically connecting two or more circuit elements to each other. — 180

END

FIG. 3

200

230    236    233

223

220

226

FIG. 4A

210

240g 240    240g    240

230    240s    236    233    232 240s    240g
223    232    240d

240s    240s    240s
240d 220    240d    240d

226    240d    210

FIG. 4B

250 240 240g    250 240    250    240g    258
230    240s    236    240g    233    240    240d

223

240s    226 240d 220    240s    240s    240s

240d    240d    210

FIG. 4C

FIG. 4D

FIG. 4E

FIG. 4F

FIG. 4G

FIG. 5

FIG. 6

240    240g    240g    240s    240s    240g    240    240s    240d

240s    240d    235    235    250    7B    270    280    245    250    245    250    245    280    250

**FIG. 7A**

240s    240g    250    245    245    240g    240d    250    240d

270    220    240s    270

280    240d    240s    280    240s

**FIG. 7B**

240x    295    250    240y    240g

240g    245    240d

240s    240d    220    240s    270    280

**FIG. 8**

FIG. 9A

FIG. 9B

FIG. 9C

FIG. 10A

FIG. 10B

FIG. 10C

FIG. 11

FIG. 12

FIG. 13

1100

1121

1119

1127

1113  1117  1128

1121  1114  1118

FIG. 14

1120

1129

1100

1113  1117  1128

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2010078779 A1, Barth
- US 8357935 B
- US 20110012199 A
- US 20120088339 A1